(19) Europäisches Patentamt / European Patent Office / Office européen des brevets

(11) **EP 3 245 478 B1**

(12) **EUROPÄISCHE PATENTSCHRIFT**

(45) Veröffentlichungstag und Bekanntmachung des Hinweises auf die Patenterteilung:
**27.12.2023 Patentblatt 2023/52**

(21) Anmeldenummer: **16703068.3**

(22) Anmeldetag: **15.01.2016**

(51) Internationale Patentklassifikation (IPC):
**G01C 21/20** $^{(2006.01)}$  **G01C 21/16** $^{(2006.01)}$

(52) Gemeinsame Patentklassifikation (CPC):
**G01C 21/206; G01C 21/1654**

(86) Internationale Anmeldenummer:
**PCT/EP2016/050817**

(87) Internationale Veröffentlichungsnummer:
**WO 2016/113411 (21.07.2016 Gazette 2016/29)**

(54) **LOKALISIERUNGSVORRICHTUNG UND VERFAHREN ZUR LOKALISIERUNG**

LOCALIZATION APPARATUS AND LOCALIZATION METHOD

DISPOSITIF DE LOCALISATION ET PROCÉDÉ DE LOCALISATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.01.2015 DE 102015100591**
**20.03.2015 DE 102015205097**

(43) Veröffentlichungstag der Anmeldung:
**22.11.2017 Patentblatt 2017/47**

(73) Patentinhaber: **Fraunhofer-Gesellschaft zur Förderung**
**der angewandten Forschung e.V.**
**80686 München (DE)**

(72) Erfinder:
• **KLIPP, Konstantin**
**10585 Berlin (DE)**
• **WILLAREDT, Jonas**
**10555 Berlin (DE)**
• **ROSÉ, Helge**
**10577 Berlin (DE)**
• **RADUSCH, Ilja**
**10967 Berlin (DE)**

(74) Vertreter: **Maikowski & Ninnemann**
**Patentanwälte Partnerschaft mbB**
**Postfach 15 09 20**
**10671 Berlin (DE)**

(56) Entgegenhaltungen:
**US-A1- 2013 179 074**

• **SEONG-EUN KIM ET AL: "Indoor positioning system using geomagnetic anomalies for smartphones", INDOOR POSITIONING AND INDOOR NAVIGATION (IPIN), 2012 INTERNATIONAL CONFERENCE ON, IEEE, 13. November 2012 (2012-11-13), Seiten 1-5, XP032313253, DOI: 10.1109/IPIN.2012.6418947 ISBN: 978-1-4673-1955-3**
• **CHIRAKKAL VINJOHN V ET AL: "An efficient and simple approach for indoor navigation using smart phone and QR code", THE 18TH IEEE INTERNATIONAL SYMPOSIUM ON CONSUMER ELECTRONICS (ISCE 2014), IEEE, 22. Juni 2014 (2014-06-22), Seiten 1-2, XP032630982, DOI: 10.1109/ISCE.2014.6884282 [gefunden am 2014-08-26]**
• **E. FOXLIN: "Pedestrian Tracking with Shoe-Mounted Inertial Sensors", IEEE COMPUTER GRAPHICS AND APPLICATIONS, Bd. 25, Nr. 6, 1. November 2005 (2005-11-01), Seiten 38-46, XP055211467, ISSN: 0272-1716, DOI: 10.1109/MCG.2005.140**
• **SILBERT MARK ET AL: "Comparison of a grid-based filter to a Kalman filter for the state estimation of a maneuvering target", SIGNAL AND DATA PROCESSING OF SMALL TARGETS 2011, SPIE, 1000 20TH ST. BELLINGHAM WA 98225-6705 USA, vol. 8137, no. 1, 12 September 2011 (2011-09-12), pages 1-10, XP060021183, DOI: 10.1117/12.892477 [retrieved on 1901-01-01]**

- **JINGBIN LIU ET AL: "A Hybrid Smartphone Indoor Positioning Solution for Mobile LBS", SENSORS, vol. 12, no. 12, 12 December 2012 (2012-12-12), pages 17208-17233, XP055290853, CH ISSN: 1424-8220, DOI: 10.3390/s121217208**

**Beschreibung**

Die Erfindung betrifft eine Lokalisierungsvorrichtung mit den Merkmalen der Anspruchs 1 und ein Verfahren zur Lokalisierung mit den Merkmalen des Anspruchs 10.

Die Bedeutung der Lokalisierung von Personen und / oder Geräten hat in den letzten Jahren durch eine massenhafte Nutzung von Navigationsgeräten, z.B. in Autos, an Bedeutung gewonnen.

Innerhalb von Gebäuden (z.B. Kaufhäusern, Flughäfen, Fabriken, Bürohäusern, Bahnhöfen) hat sich allerdings noch keine Lösung durchgesetzt, die die Ansprüche an eine In-Gebäude Lokalisierung erfüllt. Ein im Alltag zu gebrauchendes In-Gebäude Positionierungssystem sollte:

- Mit möglichst wenig zusätzlicher Infrastruktur auskommen.
- Eine Lokalisierungsgenauigkeit von ca. zwei Metern aufweisen.
- Lokalisationen, d.h. Positionen in Echtzeit liefern können.
- Relativ günstig zu installieren und zu warten sein.

Viele existierende Lösungen erfüllen nicht gleichzeitig alle genannten Punkte. Viele Lösungen basieren auf dem Abgleich von empfangenen Signalstärken von Routern mit einer vorher vermessenen "Signalstärke Fingerabdruck"-Karte. Das Problem bei diesen Lösungen ist unter anderem, dass die Signalstärke an einem Ort über die Zeit schwankt, z.B. durch Interferenzen. Somit ist mit dieser Lösung alleine keine befriedigende Genauigkeit, welche in einem angemessenen Kostenverhältnis steht, zu erreichen. Andere Lösungen benutzen Beschleunigungs- und Rotationssensoren, um z.B. die Schritte eines Nutzers und deren Richtung und Weite zu bestimmen. Es kommen Pedometer, aber auch Fußsensoren zum Einsatz. Hierbei wird jedoch eine bekannte Startposition vorausgesetzt oder über beispielsweise einen Partikelfilter durch Karteninformationen während einer Kalibrierungsphase bestimmt. Diese Kalibrierungsphase führt jedoch nur in entsprechenden Gebäudestrukturen und nach gewisser Zeit zum Erfolg.

S.-E. Kim, "Indoor Positioning System Using Geomagnetic Anomalies for Smartphones", 2012 International Conference in Indoor Positioning and Indoor Navigation, Nov 13-15, 2012, offenbart ein Indoor-Navigarionssystem unter Verwendung einer magnetischen Karte.

M.Silbert et al., "Comparison of a grid-based filter to a Kalman filter for the state estimation of a maneuvering target", SPIE Proc. vol. 8137, 81370J, offenbart einen gridbasierten Filter zur Positionsschätzung.

J.Liu et al., "A Hybrid Smartphone Indoor Positioning Solution for Mobile LBS", Sensors 2012, 12, 17208-17233 offenbart gridbasierte Indoor-Navigation basierend auf dreidimensionalen Inertial- und Magnetometerdaten.

Ein weiteres weit verbreitetes Problem hierbei ist die Bestimmung der Richtung, welche einem Schritt zuzuordnen ist. Die Bewegungsrichtung wird in der Regel mit einem Kompass bestimmt, was in den meisten Gebäuden aufgrund starker Ablenkungen des Erdmagnetfeldes durch metallische Strukturen zu einem schlechten Ergebnis führt. Andere Lösungen verwenden Rotationssensoren, um die Richtung in Bezug auf eine Anfangsausrichtung zu bestimmen. Aufgrund von nicht vernachlässigbaren Messfehlern nimmt die Genauigkeit dieser Richtungsbestimmung dabei aber mit der Zeit ab.

Außerdem gibt es Ansätze, welche gemessene statische Magnetfelder durch den Abgleich mit einer Magnetfeldkarte zur Ortsbestimmung entsprechend eines Fingerabdruckverfahrens nutzen. Vorhandene Lösungen haben hier jedoch den Nachteil, dass die verwendeten Merkmale rotationsabhängig sind. Es muss also sehr genau bekannt sein wie das Gerät im Erdkoordinatensystem ausgerichtet ist, was in der Praxis meist nicht mit benötigter Genauigkeit möglich ist.

Es besteht daher die Aufgabe, genauer arbeitende Vorrichtungen, Systeme und Verfahren bereitzustellen.

Die Aufgabe wird durch eine Lokalisierungsvorrichtung mit den Merkmalen des Anspruchs 1 gelöst.

Dabei werden drei Systeme, die unabhängig voneinander Daten aufnehmen, verwendet. Ein Bewegungssensorsystem mit mindestens einem Translationssensor (z.B. ein Sensor für lineare Bewegungen, ein Accelerometer, ein Inertialmessgerät für lineare Bewegungen) und mindestens einem Rotationssensor (z.B. ein Gyroskop) dient der Erfassung von auf die Lokalisierungsvorrichtung einwirkenden Linearbewegungsgrößen oder Drehbewegungsgrößen. Dies können insbesondere Linearbeschleunigungen und / oder Drehbeschleunigungen, aber auch Positionsmessungen oder Geschwindigkeitsmessungen sein.

Mindestens eine Magnetometervorrichtung dient der Erfassung von magnetischen Felddaten im Lokalisierungsraum, wobei rotationsinvariante magnetische Merkmale mittels einer internen oder externen Datenverarbeitungsvorrichtung aus gemessenen magnetischen rotationsabhängigen Rohdaten bestimmbar sind. Durch die Verwendung von rotationsinvarianten magnetischen Merkmalen müssen gemessene rotationsabhängige Magnetfelddaten nicht korrigiert werden. Damit kann z.B. die Lokalisierungsvorrichtung beliebig im Lokalisierungsraum räumlich orientiert gehalten werden, da die erfassten Magnetfelddaten auf rotationsinvariante Daten reduziert werden.

Ein Mittel dient der Bestimmung einer absoluten Position der Lokalisierungsvorrichtung im Lokalisierungsraum.

Durch eine integrierte Datenverarbeitungsvorrichtung oder eine Kopplung zu einer externen Datenverarbeitungsvorrichtung sind die Messdaten des Bewegungssensorsystems unter Verwendung einer vorgespeicherten Magnetfeldkarte mit magnetischen Parametern, insbesondere unter Verwendung der rotationsinvarianten Merkmale, von mindestens Teilen des Lokalisierungsraums und zur Verarbeitung der bestimmten absoluten Position vorhanden.

Durch die Auswertung von drei unabhängig voneinander gewonnen physischen Daten (z.B. den Bewegungsdaten, den rotationsinvarianten Magnetfelddaten und z.B. den drahtlosen Signalen einer Funkbake) kann effizient eine erhöhte Ortungsgenauigkeit der Lokalisierungsvorrichtung im Lokalisierungsraum erreicht werden.

In einer vorteilhaften Ausführungsform sind der mindestens eine Translationssensor, der mindestens eine Rotationssensor und / oder die mindestens eine Magnetometervorrichtung als ein-achsig, zwei-achsig und / oder drei-achsiges Messmittel ausgeführt. Damit kann die Position und Orientierung entlang einer eindimensionalen Umgebung, wie z.B. einem Flur, in einer Ebene oder in einem Raum bestimmt werden.

Auch ist es vorteilhaft, wenn eine Ausführungsform der Lokalisierungsvorrichtung als mobiles Handgerät oder als tragbares System für einen Nutzer ausgebildet ist.

Zur Berechnung der rotationsinvarianten Magnetfelddaten wird in einer Ausführungsform mit dem Bewegungssensorsystem die lokale Richtung des Erdschwerfeldes gemessen.

Auch kann in einer Ausführungsform zur Gewinnung eines rotationsinvarianten Merkmales ein gemessener Magnetfeldvektor auf die Richtung des lokalen Erdschwerevektors projiziert werden.

In einer weiteren vorteilhaften Ausgestaltung weist das Mittel zur Bestimmung einer absoluten Position der Lokalisierungsvorrichtung ein Funkmodul zum Empfang von drahtlosen Signalen, insbesondere Funkdaten einer Funkbake im Lokalisationsraum auf.

Alternativ oder zusätzlich ist es möglich, dass das Mittel zur Bestimmung der absoluten Position der Lokalisierungsvorrichtung ein Auswertungsmittel für einen optischen Marker, insbesondere einen QR-Code aufweist. Zum Beispiel kann eine absolute Position im Raum durch die Aufnahme eines QR-Codes mit einer Kameravorrichtung erfolgen, um die absolute Position zu bestimmen.

Die Genauigkeit kann verbessert werden, wenn in einer Ausführungsform mindestens ein Sensorteil an einer Extremität des Nutzers Daten über Bewegungsgrößen an der Extremität erfasst und an die Datenverarbeitungsvorrichtung überträgt. So können mittels eines Fußsensors die Schrittbewegungen genauer erfasst werden, so dass die Positionsdaten auf Grund der Bewegung präzisier sind und daher bei der Fusion der Daten ein verbessertes Ergebnis liefern können. Die Fusion der Daten kann z.B. in der Datenverarbeitungsvorrichtung durchgeführt werden.

Dabei ist in einer Ausführungsform insbesondere zur Bearbeitung der rotationsinvarianten Merkmale ein Filter, insbesondere ein probabilistischer Filter, ganz insbesondere ein probabilistischer gridbasierter Bayesfilter verwendbar. Ein Filter kann in diesem Zusammenhang auch als Estimator ausgebildet sein.

Das Problem wird auch durch ein Verfahren mit den Merkmalen des Anspruchs 9 gelöst.

Das Verfahren zur Lokalisierung einer Lokalisierungsvorrichtung weist dabei die folgenden Schritte a) bis c) auf, die mindestens einmal in beliebiger Reihenfolge ausgeführt werden können:

> a) Berechnung der Richtung und Länge einer Bewegung der mindestens einen Lokalisierungsvorrichtung ausgehend von der Anfangsposition durch einen Translationssensor und einen Rotationssensor zur Bestimmung eines ersten Positionsdatensatzes,
> b) Berechnung eines zweiten Positionsdatensatzes unter Auswertung einer vorgespeicherten Magnetfeldkarte und Messergebnissen einer Magnetometervorrichtung, wobei zur Verbessrung der Genauigkeit rotationsinvariante magnetische Merkmale mittels der Datenverarbeitungsvorrichtung bestimmbar sind.
> c) Bestimmung eines dritten Positionsdatensatzes der mindestens einen Lokalisierungsvorrichtung in Abhängigkeit von einer absoluten Position im Lokalisationsraum.

Anschließend erfolgt eine Fusionierung der ersten, zweiten und dritten Positionsdatensätze, insbesondere durch ein statistisches Verfahren zu einer berechneten Position der mindestens einen Lokalisierungsvorrichtung. Die Fusion wird in einer Datenverarbeitungsvorrichtung vorgenommen.

Die Genauigkeit des Verfahrens lässt sich verbessern, wenn die aktuelle Position in Abhängigkeit von einem drahtlosen Signal, insbesondere von Funkwellen einer Funkbake und / oder in Abhängigkeit von einem Positionsmarker, insbesondere einem optischen Marker, bestimmt wird.

In einer weiteren Ausführungsform des Verfahrens wird die aktuelle Position der mindestens einen Lokalisierungsvorrichtung gleich der absoluten Position gesetzt, insbesondere der einer Position einer Funkbake und / oder einer Position des Positionsmarkers, wenn die mindestens eine Lokalisierungsvorrichtung sich innerhalb einer vorbestimmten Entfernung der absoluten Position befindet.

In einer weiteren Ausführungsform erfasst mindestens ein Sensorteil an einer Extremität des Nutzers, insbesondere als Fußsensor, Daten über Bewegungsgrößen an der Extremität und überträgt diese an die Datenverarbeitungsvorrichtung.

Auch können in einer Ausführungsform zur Bearbeitung der rotationsinvarianten magnetischen Merkmale ein Filter, insbesondere ein probabilistischer Filter, ganz insbesondere ein probabilistischer gridbasierter Bayesfilter verwendet werden.

Auch kann das Bewegungssensorsystem die lokale Richtung des Erdschwerefeldes erfassen.

Beispielhafte Ausführungsformen der Lokalisierungsvorrichtung und des Verfahrens zur Lokalisierung werden anhand von Figuren beschrieben. Dabei zeigen

Fig. 1        eine Lokalisierungsvorrichtung in einem Gebäude als Lokalisierungsraum;

Fig. 2A      ein Flussdiagramm für die Kalibrierungsphase;

Fig. 2B      ein Flussdiagramm für die Aufnahme einer Magnetfeldkarte;

Fig. 3        ein Flussdiagramm für eine Lokalisierungsphase einer Lokalisierungsvorrichtung;

Fig. 4        eine schematische Darstellung von vier Zellen mit Magnetfeldabweichungen.

Die im Folgenden beispielhaft darstellten Ausführungsformen ermöglichen es, innerhalb eines Gebäudes die Position einer Vorrichtung (nachfolgend Lokalisierungsvorrichtung 1) zu berechnen, auch ohne dass z.B. ein GPS Signal vorliegt. Die

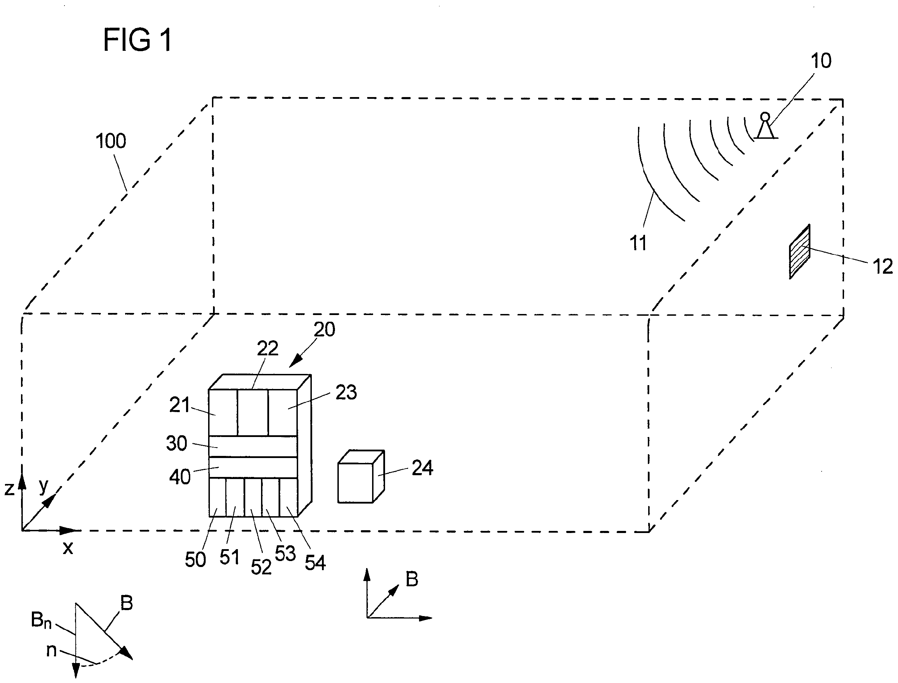

Lokalisierungsvorrichtung 1 ist in der Fig. 1 in einem Lokalisierungsraum 100 angeordnet, wobei aus Gründen der Vereinfachung der Lokalisierungsraum 100 hier als Quader dargestellt ist. Im Allgemeinen wird der Lokalisierungsraum 100 sehr viel komplexer ausgebildet sein, wie dies bei Gebäuden wie Bahnhöfen, Fabriken oder Flughäfen der Fall ist. Insbesondere kann sich der Lokalisierungsraum 100 auch über mehr als eine Ebene erstrecken und geometrisch komplex aufgebaut sein. Es ist nicht zwingend, dass sich der Lokalisierungsraum 100 ganz oder teilweise in einem Gebäude befindet. Der Lokalisierungsraum 100 kann ganz oder teilweise im Freiraum angeordnet sein. Damit kann z.B. ein Übergang von einem anderen Lokalisierungsverfahren auf das hier beschriebene sichergestellt werden.

Zunächst wird die initiale Position der Lokalisierungsvorrichtung 1 durch die Messung der Feldstärke eines von einem drahtlosen Sender 10, hier einer Funkbake 10 (auch Funkbeacon genannt) emittierten spezifischen Funksignals 11 berechnet. Entfernt sich der Nutzer der Lokalisierungsvorrichtung 1 von der Funkbake 10, wird der zurückgelegte Weg durch mindestens einen Translationssensor 21 und mindestens einen Rotationssensor 22 berechnet, so dass die Position und die Ausrichtung der Lokalisierungsvorrichtung 1 bekannt ist. Der Rotationssensor 22 kann dabei den Drehwinkel, die Drehgeschwindigkeit und / oder die Drehbeschleunigung erfassen.

Die Funkbake 10 dient dabei der Bestimmung einer absoluten Position im Lokalisierungsraum 100.

Zusätzlich oder alternativ kann dazu auch in Positionsmarker 12, wie z.B. ein QR-Code zur Bestimmung der absoluten Position dienen.

Befindet sich die Lokalisierungsvorrichtung 1 bzw. der Nutzer erneut im Nahbereich eines solchen Funksignals 11, so werden Position und Ausrichtung der Lokalisierungsvorrichtung 1 korrigiert. Zusätzlich ist es möglich, aufgrund des Vergleichs von aktuell ermittelten oder berechneten rotationsinvarianten Magnetfeldmerkmalen und einer Karte von selbigen Magnetfeldmerkmalen und deren Positionen mithilfe eines probabilistischen Filters (in diesem Fall auch als Estimator bezeichnet) die Position einer Lokalisierungsvorrichtung 1, welche mit einer Magnetometervorrichtung ausgestattet ist, zu bestimmen. Dies wird im Folgenden noch beschrieben.

Die hier beschriebenen Ausführungsformen von Lokalisierungsvorrichtungen 1, von Systemen zur Lokalisierung von Lokalisierungsvorrichtungen 1 und Verfahren zur Lokalisation können insbesondere als Ortungskomponente in einem Indoor Positionierungs- oder Navigationssystem für Fußgänger eingesetzt werden; die Ausführungsformen sind aber - wie oben bereits erwähnt - nicht auf den Indoor-Bereich beschränkt.

Bislang gibt es keine breit verfügbare Navigation für geschlossene Gebäude. Eine Navigation endet üblicherweise vor dem Gebäude, zu dem man geführt werden will. Mit den hier vorgeschlagenen Ausführungsformen ist es nun möglich, auch innerhalb von Gebäuden eine Navigation und Orientierung zu ermöglichen.

Das ist besonders hilfreich in großen und / oder komplex geformten Lokalisationsräumen 100 wie Flughäfen, Fabriken, Bürogebäuden, Einkaufszentren oder Bahnhöfen, in denen Nutzer sich mithilfe der Lokalisierungsvorrichtungen 1 orten bzw. navigieren lassen können. Die Ortung kann insbesondere für sehbehinderte Personen, Blinde oder auch autonome Maschinen eingesetzt werden.

Dabei werden an sich schon bekannte Lösungen verwendet und erweitert, um eine deutlich höhere Positionsgenauigkeit zu erzielen. So werden Funkbaken 10 nur im zuverlässigeren Nahbereich verwendet. Die Datensätze werden mit Schrittalgorithmen in zu einer deutlich verbesserter Richtungsgenauigkeit fusioniert. Es können zudem rotationsinvariante Magnetfeldmerkmale, sowie Karteninformationen durch einen probabilistischen Filter mit in die Fusion einfließen. Ebenfalls innovativ ist die Bestimmung der Bewegungsrichtung anhand von Inertialsensorik in Kombination mit einer Magnetfeldkarte und gemessenen Magnetfeldern.

Die Lokalisierungsvorrichtung 1, welche insbesondere zur Indoorlokalisierung verwendet wird, weist mindestens ein Bewegungssensorsystem 20 mit einem drei-achsigen Translationssensor 21, einem drei-achsigen Rotationssensor 22 (z.B. Gyroskop) und einer drei-achsigen Magnetometervorrichtung 23 auf. Mit dem Translationssensor 21 sind insbesondere lineare Beschleunigungen oder lineare Geschwindigkeiten, mit dem Rotationssensor 23 insbesondere Drehbeschleunigungen oder Drehgeschwindigkeiten zu erfassen.

Die Magnetometervorrichtung 23 kann die magnetische Feldstärke und / oder Flussdichte des Erdmagnetfeldes und deren Änderungen bestimmen.

Alle drei Sensoren 21, 23, 23 sind hier drei-achsig ausgebildet, so dass sie die Werte räumlich erfassen können, also in drei Dimensionen. Es ist aber in alternativen Ausführungsformen möglich, auch einachsige, zweiachsige Translationssensoren 21 und Rotationssensoren 22 zu verwenden, wenn das Lokalisierungsgerät 1 nur entlang einer Kurve (oder Gerade) oder einer Ebene lokalisiert werden soll. Es ist nicht zwingend, dass der Translationssensor 21 und der Rotationssensor 22 als getrennte Bauelemente ausgebildet sein müssen; die Sensoren 21, 22 können auch in ein Bauteil integriert sein, das translatorische und rotatorische Bewegungen erfasst.

Im Ergebnis werden in der dargestellten Ausführungsform drei lineare Beschleunigungskomponenten durch die Translationssensoren 21 und drei rotatorische Beschleunigungskomponenten durch die Rotationssensoren 22 erfasst, so dass eine vollständige Bestimmung der Lage des Lokalisationsgerätes 1 im Lokalisationsraum 100 möglich ist.

Ebenfalls weist es eine Datenverarbeitungsvorrichtung 30 (Rechen- und Speichereinheit) sowie ein Funkmodul 41 zum Empfang der Funksignale der Funkbaken 10 auf. Diese Hardwarekomponenten können beispielsweise in einem Smartphone verbaut sein. Das Smartphone wird fest am Körper auf Hüft- oder Brusthöhe getragen oder es wird in Bewegungsrichtung in der Hand gehalten. Damit weist das Smartphone eine Lokalisierungsvorrichtung 1 auf oder kann sogar ganz als solche aufgefasst werden.

In alternativen Ausführungsformen sind das Bewegungssensorsystem 20, die Datenverarbeitungsvorrichtung 30 und das Funkmodul 41 in einem eigenständigen Gehäuse oder zusammen mit einer anderen Einrichtung, wie z.B. einem Funkgerät, gekoppelt oder in solche integriert. Die Datenverarbeitungsvorrichtung 30 kann ganz oder teilweise auch außerhalb der Lokalisierungsvorrichtung 1 angeordnet sein.

Die Lokalisierungsvorrichtung 1 weist ferner ein Orientierungsmodul 50 zur Bestimmung eines Richtungsvektors Lokalisierungsvorrichtung 1, ein Schritterkennungsmodul 51 und ein Modul zur Bestimmung der Bewegungsrichtung 52 auf.

Das Orientierungsmodul 50 berechnet, für die Sensorsysteme einer Lokalisierungsvorrichtung (z.B. Handy und Fußsensor) die Drehung der Sensoren im Raum. Ergebnis ist z.B. ein Quaternion. In der Regel ist das die Ausrichtung gegenüber dem Boden und die relative Gierbewegung.

Das ist u.a. nötig um z.B. Sensorwerte zu interpretieren und die Erdbeschleunigung von den richtigen Komponenten abzuziehen.

Das Bewegungsrichtungsmodul 52 bezieht sich auf die Sensordaten des Bewegungssensorsystems, welches in Bewegungsrichtung gehalten wird (z.B. als Handy). Es gibt die absolute Bewegungsrichtung des Nutzers bezüglich Norden an. Dazu benutzt es den relativen Gierwinkel vom Orientierungsmodul, die Magnetfeldkarte 31, die Magnetometervorrichtung und die aktuellen Positionsschätzungen.

Das Schritterkennungsmodul 51 funktioniert z.B. wie ein bekanntes Pedometer in einem Smartphone, mit dem die Schrittfrequenz anhand von Beschleunigungsmessungen ermittelt wird. Der z.B. mittels einer Software ermittelte Abstand zwischen Beschleunigungspeaks kann als ein Schritt gedeutet werden. Wenn eine mittlere Schrittlänge angenommen (oder gemessen) wird, kann damit die zurückgelegte Entfernung bestimmt werden.

Diese Module 50, 51, 52 empfangen die Messergebnisse des Bewegungssensorsystems 20, der Magnetometervorrichtung 23 und / oder des Funkmoduls 41 und können als Software oder Hardware implementiert sein.

Zudem muss zuvor eine Magnetfeldkarte 31 des Lokalisierungsraums 100 (d.h. der räumliche Bereich, in dem die Lokalisierungsvorrichtung 1 lokalisiert werden kann) oder dessen Teilbereiche aufgezeichnet werden. In den hier dargestellten Ausführungsformen ist die Magnetfeldkarte 31 in der Datenverarbeitungsvorrichtung 30 gespeichert.

In alternativen Ausführungsformen kann die Magnetfeldkarte 31 in einer zentralen Datenverarbeitungsvorrichtung 30 gespeichert sein, wobei notwendige Daten zu der Lokalisierungsvorrichtung 1 übertragen werden.

In der Magnetfeldkarte 31 können mindestens die Richtungsabweichungen des Magnetfeldes B an verschiedenen Positionen des Lokalisierungsraums 100 festgehalten werden. Das Funkmodul 41 der Lokalisierungsvorrichtung 1 erkennt Funkbaken 10 im Nahbereich und ordnet sie einer Position im Lokalisierungsraum 100 zu.

Das Orientierungsmodul 50 erfasst Daten vom Translationssensor 21 und vom Rotationssensor 22 und fusioniert sie, um damit die Orientierung der Lokalisierungsvorrichtung 1 hinsichtlich dessen absoluter Ausrichtung gegenüber dem Boden des Lokalisierungsraumes 100 zu bestimmen und eine relative Gierbewegung der Sensoren 21, 22 zu erfassen.

Unter Fusion wird hier verstanden, dass Daten aus unterschiedlichen Quellen, z.B. dem Bewegungssensorsystem 20 und der Magnetometervorrichtung 22, so verrechnet werden, dass eine konsolidierte, d.h. genauere Lokalisierungsinformation erhalten wird. Das Schritterkennungsmodul 51 detektiert typische Schrittbewegungen eines Nutzers durch einen Beschleunigungssensor als Translationssensor 21.

Das Modul zur Bestimmung der Bewegungsrichtung 52 ermittelt die absolute Ausrichtung der Lokalisierungsvorrichtung 1 hinsichtlich der Richtung gen Norden durch die gemessene Magnetfeldrichtung unter Verwendung der Magnetfeldkarte 31 vorzugsweise an Positionen der Funkbake 10. Zwischen den Positionen, an denen die Magnetfeldkarte 31 verwendet wird, muss das Modul zur Bestimmung der Bewegungsrichtung 52 die

Richtung durch Inertialsensorik (Bewegungssensorik) relativ zur letzten bekannten Richtung bestimmen.

Werden diese Module mit den genannten Eigenschaften fusioniert, so ist eine genaue Positionsbestimmung möglich.

In einer alternativen Ausführungsform kann das Schritterkennungsmodul 51 auch ein zweites Bewegungssensorsystem verwenden, welches an einem Körperteil des Nutzers befestigt ist, das bei einer Laufbewegung eine Bewegungs- und eine Stillstandsphase erfährt. Dies ist beispielsweise am Fuß der Fall. Der Fußsensor kann nach jedem Schritt eine Schrittlänge über eine drahtlose Verbindung übertragen. Das Smartphone als Datenverarbeitungsvorrichtung 30 fusioniert dann die Ergebnisse der Module 50, 51, 52, wodurch eine sehr hohe Genauigkeit möglich ist.

Ebenfalls ist eine Fusion mit rotationsinvarianten Magnetfeldmerkmalen durch ein Modul zur Nutzung von rotationsinvarianten magnetischen Merkmalen 54 sinnvoll. Hierfür müssen diese Merkmale aus zuvor ausgemessenen Rohdaten berechnet werden und in der Magnetfeldkarte 31 festgehalten werden. Ein probabilistischer gridbasierter Bayesfilter fusioniert bei der Lokalisierung diese Merkmale mit dem Schritterkennungsmodul 51, dem Bakenmodul und Bewegungsrichtungsmodul 52. Ebenfalls sinnvoll ist es, die Information über benachbarte Zellen beziehungsweise über die Positionen von Hindernissen, wie Wänden, mit in den probabilistischen Filter einzuarbeiten. Grundsätzlich ist es auch möglich, eine andere Bauform eines Filters oder Estimators zur Fusion zu verwenden.

Je nach Konfiguration müssen verschiedene Merkmale (z.B. Richtungsinformation, rotationsinvariante magnetische Merkmale) in der Magnetfeldkarte 31 gespeichert werden. Das abzudeckende Gebiet, d.h. der Lokalisierungsraum 100, wird in Zellen eingeteilt. Diese können beispielsweise eine Größe von etwa einem Quadratmeter haben.

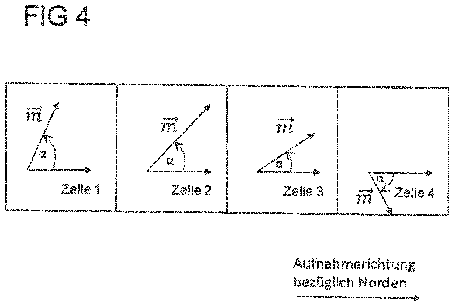

Die Merkmale werden aufgenommen und für jede Zelle gespeichert, was im Zusammenhang mit der Fig. 4 näher beschrieben wird. Um eine Korrektur der Bewegungsrichtung, wie sie weiter unten beschrieben wird, zu erreichen, müssen die Abweichungen des gemessenen Magnetfeldvektors zum ungestörten Erdmagnetfeld festgehalten werden. In Fig. 4 sind vier Zellen dargestellt, wobei in jeder der Zellen der Magnetfeldvektor $\vec{m}$ eine Winkelabweichung a gegenüber der wahren Nordrichtung aufweist. Die Winkelabweichung a wird vorab abgespeichert.

Dabei wird die Differenz zwischen dem Winkel $\alpha$ bezüglich Norden, in dem das Aufnahmegerät gehalten wurde und dem Winkel des bei der Aufnahme gemessenen Magnetfeldes in der xy-Ebene errechnet, die parallel zum Boden liegt. Der Mittelwert und die Varianz aller in einer Zelle vorkommenden Differenzen werden errechnet und abgespeichert. Wie viele Zellen abgespeichert werden ist variabel.

Besondere Präferenz sollten aber Zellen mit einer geringen Standardabweichung des Winkels haben und die im Nahbereich einer Funkbake 10 liegen.

Wird eine Ausführungsform mit dem Modul 54 "Nutzung von rotationsinvarianten magnetischen Merkmalen" verwendet, so müssen diese Merkmale in der Magnetfeldkarte 31 festgehalten sein.

Vor der Kartenaufnahme muss die Magnetometervorrichtung 23 kalibriert werden. Für jedes Merkmal wird der Mittelwert und die Standardabweichung aller in einer Zelle vorkommenden Werte bestimmt und gespeichert. Ebenfalls abgespeichert werden die Verbindungen der Zellen, wodurch das Wegenetz abgespeichert ist.

Möglich ist es zudem, an den Ein- und Ausgängen des Gebäudes, d.h. des Lokalisationsraumes 100, Zellen im Außenbereich anzulegen und diese als solche zu kennzeichnen. So kann später gut erkannt werden, wenn der Nutzer das Gebäude verlassen hat, indem untersucht wird, ob die nächstgelegene Zelle zur errechneten Position als Außen- oder Innenzelle gekennzeichnet ist. Alternativ können auch die Gebäudegrenzen abgespeichert werden.

Die Ausführungsformen basieren auf einer gezielten Kombination der Einzelmodule, welche im Folgenden beschrieben werden.

Die Module können z.B. in einem Smartphone, welches über die benötigten Komponenten verfügt, oder auf einem externen Bewegungssensorsystem (z.B. integriert mit einem Funkgerät oder einem anderen mobilen Handgerät) mit der Datenverarbeitungsvorrichtung 30 implementiert werden. Es ist aber auch möglich, dass die Datenverarbeitungsvorrichtung 30 ganz oder teilweise in dem Smartphone integriert ist.

Dabei ist das Orientierungsmodul 50 wichtig, welches die Orientierung des Bewegungssensorsystems 20 in der Lokalisierungsvorrichtung 1 mindestens hinsichtlich der Ausrichtung gegenüber dem Boden des Lokalisierungsraums 100 errechnet.

Es kann aber auch die volle Ausrichtung im Erdkoordinatensystem bestimmt werden. Diese Berechnung wird für jedes verwendete Bewegungssensorsystem 20 durchgeführt.

Ebenfalls benötigt wird das mindestens eine Schritterkennungsmodul 51. Ein am Körper befestigter oder in der Hand gehaltener Sensor bzw. ein Smartphone kann Schrittevents erkennen. Diese Information kann beispielsweise durch eine angenommen feste Schrittweite eingearbeitet werden.

Sinnvoll ist hier -- wie beschrieben -- eine Fusion mit Magnetfeldmerkmalen in einem Bayesfilter.

Die andere, deutlich genauere Variante ist die Verwendung eines Fußsensors. Dieser kann den zurückgelegten Weg in den drei Raumkoordinaten an das Fusionsmodul senden.

Viele der Einzelmodule geben neben dem Schätzwert eine Wahrscheinlichkeitsverteilung aus. Diese kann später zur Fusion im probabilistischen Filter verwendet werden.

Das Orientierungsmodul 50 hat die Aufgabe, die Ausrichtung der Lokalisierungsvorrichtung 1 im Erdkoordinatensystem oder einem selbst festgelegten Koordinatensystem, d.h. im Lokalisierungsraum 100, zu bestimmen.

Für jedes verwendete Bewegungssensorsystem 20, wie beispielsweise das Smartphone oder einen Fußsensor, muss jeweils ein Orientierungsmodul 50 implementiert werden. Die Orientierung kann in Form von Eulerwinkeln oder eines Quaternions repräsentiert werden.

Hierzu wird die Inertialsensorik bestehend aus mindestens einem multiaxialen Translationssensor 21 und mindestens einem multiaxialen Rotationssensor 22 und mindestens einer Magnetometervorrichtung 23 bestimmt.

Durch eine gezielte Fusion von Translations- und Rotationsdaten können Driftfehler des Rotationssensors 22 ausgeglichen werden. Hierfür kann beispielsweise der Fusionsalgorithmus von Sebastian Madgwick verwendet werden (UK Sebastian O.H. Madgwick. Harrison; Vaidyanathan Dept. of Mech. Eng.; Univ. of Bristol, Bristol. Estimation of imu and marg orientation using a gradient descent algorithm. 2011.)

Diese Fusion wird auch 6D Sensorfusion genannt. Der Rotationssensor 22 liefert lediglich eine zu einer Anfangsausrichtung relative Information über die Drehung des Lokalisationsgerätes 1.

Der Translationssensor gibt hingegen aufgrund der Erdbeschleunigung eine absolute Information über den Roll- und Nickwinkel.

Die 6D Sensorfusion bietet keine Möglichkeit zur Bestimmung des Gierwinkels bezüglich des Erdkoordinatensystems, sofern keine Anfangsausrichtung bekannt ist.

Alternativ kann ein 9D Fusionsalgorithmus verwendet werden, welcher auch Magnetfelddaten integriert und damit auch den Gierwinkel absolut bestimmen kann.

Aufgrund von schlechten Kompassergebnissen in Gebäuden weist diese Variante jedoch in der Regel Nachteile auf. Aus diesem Grund wird vor allem die 6D Fusion verwendet, wodurch die z-Komponente des Lokalisationsgerätes 1 zuverlässig bestimmt und extrahiert werden kann. Der Gierwinkel weist jedoch eine Drift auf und ist relativ zu einer Initialausrichtung. Der Gierwinkel muss durch Kompassmessungen korrigiert werden. Dies geschieht jedoch nicht im Orientierungsmodul 50 sondern bei der Bestimmung der Bewegungsrichtung.

Aufgrund von schlechten Kompassergebnissen in Gebäuden kann diese Ausführungsform den Nachteil aufweisen, dass durch z.B. metallische Strukturen im Baumaterial und in der Inneneinrichtung der Magnetfeldvektor nicht zuverlässig nach Norden zeigt.

Aus diesem Grund kann vor allem die 6D-Fusion im Orientierungsmodul 50 ohne Magnetometervorrichtung 23 verwendet werden, wodurch die z-Komponente des Lokalisationsgerätes 1 wie zuvor beschrieben zuverlässig bestimmt und extrahiert werden kann. Der Gierwinkel der 6D Fusion ist dadurch jedoch nur relativ zu einer Initialausrichtung und weist einen Drift auf, welcher unter anderem von der Qualität des verwendeten Rotationssensors abhängt, sich aber praktisch nicht verhindern lässt. Mit der Zeit steigt also der Fehler der errechneten Gierbewegung bezüglich der Initialposition.

Um die relativen Gierwinkel in absolute Winkel beispielsweise in Bezug auf Norden umzurechnen, ist eine zuverlässige Kompassmessung oder eine andere absolute Richtungsbestimmung wie beispielsweise über optische Marker notwendig. Nicht jedes Bewegungssensorsystem 20 benötigt diese absolute Ausrichtung zwingend, deswegen wird sie nicht im Orientierungsmodul 50 berechnet. Das Modul zur Bestimmung der Bewegungsrichtung 52 nutzt die berechneten relativen Gierwinkel eines Orientierungsmoduls 51 und fusioniert sie an bestimmten Positionen mit korrigierten Magnetfeldmessungen. Dadurch werden absolute Richtungsangaben möglich gemacht und die Driftfehler werden korrigiert. Das Modul zur Bestimmung der Bewegungsrichtung 52 wird später genauer erläutert.

Im Folgenden wird die Funktion des Schritterkennungsmoduls 51 näher beschrieben. Für eine reine Schritterkennung kann die Auf- und Abbewegung des Translationssensors 21, welcher sich beispielsweise auf Hüfthöhe befindet, ausgewertet werden. Hierfür wird die z-Komponente des Beschleunigungsvektors in Erdkoordinaten verwendet. Die Beschleunigungsdaten müssen also zuvor mit Hilfe der vom Orientierungsmodul 50 errechneten Sensorausrichtung umgerechnet werden. Das Signal wird dann tiefpassgefiltert. Anschließend wird über einen Schwellenwert entschieden, ob ein Schritt erfolgt ist. Wird, wie hier dargestellt, lediglich ein Pedometer verwendet, so kann angenommen werden, dass jeder Schritt eine vordefinierte feste mittlere Schrittweite $\overline{d}_s$ mit einer Standardabweichung $\sigma_s$ hat. Nach einem erkannten Schritt wird die Wahrscheinlichkeit einer Position $r = (r_x, r_y, r_z)$ bei gegebenen Messwerten m und der letzten Position r' durch die Gauß-Funktion $P_d$ aktualisiert.

Die Begriffe Messwerte oder Messdaten beziehen sich hier auf die Eingangswerte des Filters und beinhalten z.B. auch die vorher berechneten rotationsinvarianten Magnetdaten.

Dabei beschreibt $d(r, r')$ den Euklidischen Abstand zwischen der Position $r$ und der gegebenen vorherigen Position r', Die Funktion $d_s(m)$ kennzeichnet den Ausgangswert des Schritterkennungsmoduls 51, welcher von den gemessenen Beschleunigungsdaten abhängt.

Der Ausgangswert kann entweder den Wert $\bar{d}_s$ haben, wenn ein Schrittevent erkannt wurde oder der Wert ist 0, wenn kein solches Event vorliegt.

$$P_d(r|m,r') = \frac{1}{\sqrt{2\pi}\sigma_s} e^{-\frac{1}{2\sigma_s^2}(d(r,r')-d_s(m))^2}.$$

Alleinstehend verwertbar ist diese Information nur in Verbindung mit einer Richtungsinformation. Daher wird diese Wahrscheinlichkeit fusioniert mit der Wahrscheinlichkeit aus dem Modul der Bewegungsrichtung. Es resultiert die Wahrscheinlichkeit $P_{step}$ einer Position $r$ bei gegebenen drei-achsigen Rotationssensor 22 Messdaten, drei-achsigen Translationssensor 21 Messdaten und der letzten Position r'.

$$P_{step}(r|m,r') = \frac{P_d(r|m,r\prime)P_\Psi(r|m,r\prime)}{p(m,r\prime)},$$

$$p(m,r') = \sum P_d(r|m,r')P_\Psi(r|m,r').$$

Die Größe $P_\Psi$ wird weiter unten noch beschrieben.

Im Folgenden wird das Schritterkennungsmodul 51 mit Schrittlängenschätzung beschrieben. Eine feste Schrittlänge zu benutzen ist nachteilig da die Schrittlänge sowohl von Nutzer zu Nutzer unterschiedlich ist, als auch von der Situation abhängt, in der sich ein Nutzer befindet. Z.B. sind Schrittlängen unterschiedlich, wenn man schnell geht oder sich auf der Stelle dreht.

Um eine brauchbare Schätzung der Schrittlänge zu erhalten, muss der Nutzer das Bewegungssensorsystem 20 mit einem drei-achsigen Translationssensor 21 und drei-achsigen Rotationssensor 22 z.B. an seinem Körper befestigen. Der Ort der Befestigung sollte so gewählt sein, dass das System bei einem Schritt eine Stillstands- und eine Bewegungsphase erfährt. Zwei mögliche Positionen sind am Fuß des Nutzers oder an seinem Fußgelenk. Die mit dieser Konfiguration gemessenen Beschleunigungswerte $a_x$, $a_y$ und $a_z$ beinhalten Informationen über die Bewegung des Schrittes des Nutzers in $x$-, $y$- und $z$-Richtung. Wenn die Beschleunigung in jeder Richtung über die Zeit $t$ einmal integriert wird, bekommt man die entsprechenden Geschwindigkeiten $v_x$, $v_y$ und $v_z$ und die zurückgelegten Distanzen $dx$, $dy$ und $dz$ durch eine zweite Integration:

$$v_i = \int a_i(t)dt,$$

$$d_i = \int v_i(t)dt.$$

In der Praxis besitzen insbesondere preisgünstige MEMS Beschleunigungssensoren einen unbekannten Fehler, der nicht konstant über die Zeit und Temperatur ist. Dieser Fehler produziert einen Positionsfehler, der eine $t^2$ Abhängigkeit aufweist, bedingt durch die doppelte Integration. Vorhergehende wissenschaftliche Untersuchungen (Jaime Gomez Raul Feliz, Eduardo Zalama, Pedestrian tracking using inertial sensors, JOURNAL OF PHYSICAL AGENTS, VOL 3, NO 1, 2009) ergaben, dass dieser Fehler korrigiert werden kann, wenn der Translationssensor 21 zu einem Zeitpunkt eine bekannte Geschwindigkeit besitzt.

Da jeder Schritt eines Nutzers sowohl eine Beschleunigungsphase (Fuß in der Luft), als auch eine Stillstandsphase (Fuß auf dem Boden) besitzt, kann man für die Stillstandsphase eine Geschwindigkeit von Null annehmen. Somit erhält man den Fehler, indem man während der Stillstandsphase die Beschleunigung misst.

Es gibt verschiedene Möglichkeiten zu entscheiden, welche Phase eines Schrittes zu einer Zeit $t$ vorliegt.

Eine Möglichkeit besteht darin, die Messwerte des Rotationssensors 22 $g_x$, $g_y$ und $g_z$ zu benutzen, denn in der Stillstandsphase rotiert der Fuß nicht und somit sind die Messwerte in dieser Phase meistens nahe null. Das gilt für alle drei Achsen, weswegen die Magnitude der gemessenen Werte verwendet werden kann.

Um eine falsche Erkennung einer Stillstandsphase zu verhindern, können beispielsweise die gemessenen Magnituden mit einem Tiefpass gefiltert werden um das Signal $g_{tp}$ zu erhalten. Die Phaseninformation $S$ kann mit einer Schwellenwert-Technik extrahiert werden:

$$S(t) = \begin{cases} 1: & g_{tp}(t) \geq Schwellenwert \;\; \Rightarrow Schwingphase \\ 0: & sonst \;\; \Rightarrow Stillstandsphase \end{cases}$$

Im diskreten Fall kann man die Geschwindigkeit berechnen, indem man die Beschleunigungsmesswerte mit dem Index $t$ und dem Zeitschritt $\Delta t$ addiert. Da $a_z$ auch die Gravitation enthält, muss man den Erdgravitationsanteil davon subtrahieren, bevor man die Beschleunigung in $z$-Richtung integriert (hier diskret approximiert):

$$v_i(t) = \sum_{k=0}^{t} a_i(k)\Delta t$$

Dabei wird der Ansatz aus Gomez et al. verwendet, um die Geschwindigkeit mit dem Wissen aus der Stillstandsphase zu korrigieren. Der aktuelle Fehler der Geschwindigkeit kann berechnet werden als mittlerer Wert $\bar{v}_i$ der Geschwindigkeiten entlang jeder Achse $i$. Nach der ersten Integration steigt der Messfehler des Translationssensors 21 proportional mit $t$. Also kann der Fehler während der Schwingphase mit dem aus der Stillstandsphase bekannten Fehlerwert und der Information über den Start der Schwingphase $t_{start}$ und ihrem Ende $t_{ende}$ korrigiert werden.

$$\tilde{v}_i(t) = \begin{cases} v_i(t) - \dfrac{t - t_{start}}{t_{ende} - t_{start}} \bar{v}_i: & wenn\; S(t) = 1 \\ 0: & sonst \end{cases}$$

Nun kann die Distanz $d = (d_x, d_y, d_z)$ von der Startposition mit den korrigierten Geschwindigkeiten für je eine Achse berechnet werden:

$$d_i(t) = \sum_{k=0}^{t} \tilde{v}_i(k)\Delta t$$

Die Schrittweite sollte nach jedem Schritt aktualisiert werden, also immer beim Zeitindex $t_{ende}$. Damit ist $d(t_{ende})$ der Distanzvektor eines Schrittes. Nachdem der Distanzvektor in die Wahrscheinlichkeitsfunktion eingefügt wurde, muss das Schrittmodul für die nächsten Messwerte neu gestartet werden, so dass sich jeweils eine Weitergabe des Distanzvektors auf den vorangegangenen Schritt bezieht.

$$P_{step}(r|m,r') = \frac{1}{\sqrt{2\pi}\sigma_s} e^{-\frac{1}{2\sigma_s^2}(r - r' + d(t_{ende}))^2}$$

Ebenfalls sinnvoll ist eine Berechnung der Wahrscheinlichkeit wie im Einzelmodul mit fester Schrittweite über die Fusion mit der Bewegungsrichtung. Die feste Schrittweite wird dann jedoch ersetzt durch den Betrag der geschätzten Schrittweite in der xy-Ebene. Dies ist bei einem Fußsensor vor allem sinnvoll, da der Gierwinkel am Fuß oft nur zuverlässig aus der 6D-Fusion resultiert. Der absolute Gierwinkel bezüglich des Erdkoordinatensystems kann mit dieser Fusion der Bewegungsrichtung entnommen werden.

$$\bar{d}_s = \sqrt{d_x^2 + d_y^2}$$

$$P_d(r|m,r') = \frac{1}{\sqrt{2\pi}\sigma_s} e^{-\frac{1}{2\sigma_s^2}(d(r.r') - d_s(m))^2}$$

$$P_{step}(r|m,r') = \frac{P_d(r|m,r')P_\Psi(r|m,r')}{p(m,r')} \ .$$

Die Richtung des Schrittes wird dann angenommen als die Bewegungsrichtung. Das Modul zur Bestimmung der Bewegungsrichtung arbeitet mit Magnetfelddaten auf Hüfthöhe. Da diese konstanter sind, können hier besser Korrekturen mit der Magnetfeldkarte erfolgen.

Die Schrittlänge wird also am Fuß bestimmt und die Richtung auf Hüfthöhe.

Oft ist das Magnetfeld auf Fußhöhe stark gestört und vor allem räumlich deutlich weniger konstant als z.B. auf Hüfthöhe. Das kommt durch metallische Strukturen im Boden, dessen Einfluss quadratisch mit dem Abstand abnimmt. Daher benutzt das Orientierungsmodul 51 für das Fußsensorsystem eine 6D-Fusion (also ohne Magnetometer). Wie beschrieben, driftet also der xy-Winkel am Fuß mit der Zeit und dx und dy beziehen sich auf eine Initialausrichtung, die nicht absolut ohne Magnetometervorrichtung 23 bestimmt werden kann. Daher wird in dieser Implementierung nur der Betrag, also die absolute Schrittlänge mitgeteilt und die Richtung am Fuß zunächst verworfen.

Im Folgenden wird die Nutzung von Rotationsinvarianten der magnetischen Merkmale beschrieben.

In dem Modul 54 zur Nutzung von rotationsinvarianten magnetischen Merkmalen sollen die gemessenen Magnetfeldwerte mit den in der Magnetfeldkarte 31 gespeicherten Werten abgeglichen werden. Stimmen die Merkmale an bestimmten Positionen überein, soll die Aufenthaltshaltswahrscheinlichkeit dort hoch sein. Andere magnetische Merkmale werden auch in der US Patentanmeldung 2013/0179074 verwendet.

Die Messwerte von Magnetfelddaten hängen von der Orientierung der Magnetometervorrichtung 23 ab. Während die Ausrichtung der Magnetometervorrichtung 23 gegenüber dem Boden relativ zuverlässig vom Orientierungsmodul bestimmt werden kann, ist der Gierwinkel eine problematische Größe. Wird die Magnetometervorrichtung 23 also bei der Aufnahme der Daten anders gedreht als bei der Lokalisierung, so ergeben sich kaum Übereinstimmungen, was zu schlechten Lokalisierungsergebnissen führt. Dies kann verhindert werden durch eine Vorverarbeitung der Magnetfeldrohdaten, um rotationsinvariante Merkmale zu erhalten.

Das Magnetfeld $B(x)$ am Ort x ist ein dreidimensionaler Vektor $B = (B_x, B_y, B_z) \in \mathbb{R}^3$. Die Gruppe der dreidimensionalen Rotationen $0(3)$ ist durch die Menge aller Transformationen, die das Skalarprodukt des $\mathbb{R}^3$ invariant lassen, definiert. Damit ist das erste $0(3)$ rotationsinvariante Merkmal des Magnetfeldes die Norm seiner Flussdichte

$$|B| = \sqrt{\sum B_i^2} \ .$$

Die Untergruppe $0(2)$ der zweidimensionalen Rotationen um die z-Achse lässt die z-Komponente $B_z$ der Flussdichte invariant. Die z-Achse des Weltbezugsystems ist parallel zum Einheitsvektor n der Richtung des Erdgravitationsfeldes und kann durch den Translationssensor 21 beziehungsweise durch das 6D-Orientierungsmodul 50 bestimmt werden. Die Projektion $B_n = Bn = \Sigma B_i n_i$ der Magnetfeldkomponenten im Bezugssystem des Gerätes relativ zur z-Achse des Weltbezugsystems ist das zweite $0(3)$-rotationsinvariante Merkmal.

Eine Ausführungsform weist eine Vorverarbeitung des gemessenen dreidimensionalen Magnetfeldvektors $B = (B_x, B_y, B_z) \in \mathbb{R}^3$ in die rotationsinvarianten Merkmale auf.

1) die Norm $|B| = \sqrt{\sum B_i^2}$

2) die Projektion $B_n = B_n = \Sigma B_i n_i$

In Fig. 1 ist diese Projektion des Magnetfeldvektors B auf den normierten Erdschwerevektor n dargestellt.

Durch die Verarbeitung der drei Komponenten der Magnetflussdichte $B_x, B_y, B_z$ in die rotationsinvarianten Merkmale $|B|$ und $B_n$ gewinnt man die Rotationsinvarianz um den Preis eines Freiheitsgrades. Dieser Verlust an Information ist jedoch ein guter Kompromiss, der vor den erwähnten Orientierungsproblemen schützt und so dem beanspruchten System einen deutlichen Vorteil gegenüber bisherigen Lösungen verschafft.

Die Merkmale sind wie oben beschrieben für jede Zelle $b_i$ in der Magnetfeldkarte 31 $M_i = (|B|, B_n)_i$ gespeichert. Sofern die Abweichung $d_i = m - M_i$ zwischen gemessenen magnetischen Merkmalen $m = (|B|, B_n)$ und den Kartendaten $M_i$ gering ist, so ist die Wahrscheinlichkeit hoch, dass m der richtige Wert ist für die Zelle $b_i$. Prinzipiell kann jede Wahrscheinlichkeitsverteilung genutzt werden, die diese Bedingung erfüllt.

Im Folgenden wird eine Gauß-Verteilung $N(d_{ik}, \sigma_k)$ mit einer geeigneten Varianz $\sigma_k$ für jedes Merkmal $d_{i1} = |B|$

- $(|B|)_i$ , $d_{i2} = B_n - (B_n)_i$ angenommen. Zu jedem Zeit- oder Iterationsschritt $t$ kann die Gesamtwahrscheinlichkeit für eine Position r innerhalb einer Zelle $b_i$ für die Messwerte m berechnet werden.

$$P(m_t | r \in b_i) = \prod_k N(d_{ik}, \sigma_k)$$

Im Folgenden wird ein Bakenmodul 55 (z.B. unter Verwendung eines Bluetooth-Moduls in der Lokalisierungsvorrichtung 1) der Funkbake 10 beschrieben, mit dem die absolute Position im Lokalisierungsraum 100 bestimmbar ist. Durch das Bakenmodul 55 ist es möglich, die punktgenaue Geo-Position und Orientierung des Lokalisationsgerätes 1 (und damit ggf. die Position des Nutzers) zu bestimmen. Dazu sendet das Bakenmodul 55 mehrere Funkimpulse pro Sekunde. Die Funkimpulse enthalten unter anderem die eindeutige Identifikationsnummer bzw. die Position des Bakenmoduls 55 und können auch weitere Werte beinhalten. Die Lokalisierungsvorrichtung 1 des Nutzers empfängt diese Impulse und fragt entweder eine lokale oder entfernte Datenbank nach der Position der Funkbake 10 ab oder empfängt dessen Position direkt mit den Impulsen. Da das Funksignal 11 eine niedrige Sendestärke aufweist, kann sich die Lokalisierungsvorrichtung 1 des Nutzers nur innerhalb eines geringen (ca. <15 Meter) Radius rund um die Funkbake 10 befinden.

Um diesen Radius weiter einzuschränken kann man die Funkbake 10 z.B. nur einschalten, wenn sich ein Nutzer darunter aufhält (z. B mit einer Lichtschranke oder einem Infrarotsensor). Außerdem kann man zusätzlich die Signalstärke der empfangenen Funkimpulse 11 analysieren. Bei der Analyse ermittelt das Lokalisationsgerät 1 des Nutzers die Signalstärke von einem oder ermittelt die Signalstärken von mehreren Funksignalen 11 der Funkbake 10. Wenn dieser Wert einen Schwellenwert übersteigt, setzt man die Position des Nutzers an die Position der Funkbake 10. Der Schwellenwert ist entweder für alle Funkbaken 10 festgelegt oder er wird für eine Funkbake10 auf einen bestimmten Wert gesetzt, den das Lokalisationsgerät 1 entweder direkt mit dem Funksignal 11 der Funkbake 10 empfängt oder durch die Datenbank ermittelt.

Um die Orientierung der Lokalisationsvorrichtung 1 an einer Funkbake 10 zu bestimmen wird der magnetische Korrekturwinkel entweder durch die Funksignale 11 der Funkbake 10 direkt oder über eine Abfrage der Datenbank anhand der Magnetfeldkarte ermittelt. Das Bakenmodul 55 kann außerdem dazu verwendet werden, das Betreten des Gebäudes zu erkennen und damit den Indoorlokalisierungsmodus zu aktivieren.

Im Folgenden wird die Bestimmung der Bewegungsrichtung beschrieben. Die Bewegungsrichtung ist ein relevantes Merkmal, welches an sich zwar keine Positionsbestimmung ermöglicht, jedoch können andere Verfahren hierdurch deutlich verbessert werden. Die zuvor vorgestellten Schritterkennungsalgorithmen können beispielsweise ohne eine Richtungsinformation nicht alleinstehend zur Positionsbestimmung verwendet werden. Die Richtungsinformation basiert auf den Ergebnissen des Orientierungsmoduls 50. Die Bewegungsrichtung kann über den Gierwinkel des Bewegungssensorsystems 20, welches fest gegenüber der Bewegungsrichtung ausgerichtet ist, bestimmt werden. Hierfür eignet sich z.B. ein Smartphone, welches in Bewegungsrichtung gehalten wird oder auch ein Sensor, der fest am Körper angebracht ist und fest zur Bewegungsrichtung ist.

Wie zuvor beschrieben, wird dieser Gierwinkel durch einen 6D-Fusionsalgorithmus bestimmt. Die initiale Referenzposition kann mit Hilfe der Magnetometervorrichtung 23 bestimmt werden. Die Richtung des gemessenen Magnetfeldvektors in der xy-Ebene zeigt im ungestörten Fall nach Norden. Parallel zum Fusionsalgorithmus erfolgt eine Winkelbestimmung über die Magnetometervorrichtung 23. Durch die vorherige Aufnahme der Magnetfeldkarte 31 ist die Richtung des Magnetfeldvektors beziehungsweise die Abweichung des Kompasses an bestimmten Positionen oder Bereichen des Lokalisationsraumes 100 bekannt.

Errechnet der Lokalisierungsalgorithmus eine Position, so kann die vom Kompass gemessene Richtung korrigiert werden, sofern

• zu der Position ein Winkelkorrekturwert in der Magnetfeldkarte 31 gespeichert ist und

• die Kompassabweichung näherungsweise konstant ist im möglichen Aufenthaltsbereich.

Der mögliche Aufenthaltsbereich ergibt sich hierbei aus der aktuellen Positionsgenauigkeit. Als Korrekturpunkte eignen sich deshalb beispielsweise die Positionen der Funkbake 10. Es ist sinnvoll, die Funkbaken 10 in Bereichen des Lokalisationsraums 100 zu installieren, wo die Kompassabweichung möglichst konstant ist. An einem Korrekturpunkt wird die korrigierte Richtung des Magnetfeldvektors $\tilde{\psi}_{mag}$ aus der gemessenen Magnetfeldrichtung $\psi_{mag}$ und dem Korrekturwert $\delta_{mag}$ aus der Magnetfeldkarte 31 bestimmt.

$$\tilde{\psi}_{mag} = \psi_{mag} - \delta_{mag}.$$

Der korrigierte Messwert dient als Richtungsreferenz für das Orientierungsmodul 50. Es wird ein Offset $\delta_{6D}$ zwischen dem Gierwinkel des 6D-Fusionsalgorithmusses $\psi_{6D}$ und der Richtungsreferenz $\tilde{\psi}_{mag}$ errechnet. Diese Berechnung erfolgt an jedem Korrekturpunkt

$$\delta_{6D} = \psi_{6D} - \tilde{\psi}_{mag} \ .$$

Die Bewegungsrichtung ergibt sich dann zu jeder Zeit aus dem Gierwinkel $\psi_{6D}$ und dem aktuellstem Offset $\delta_{6D}$

$$\tilde{\psi}_{6D} = \psi_{6D} - \delta_{6D}$$

Außerdem kann davon ausgegangen werden, dass das Erdmagnetfeld außerhalb von Gebäuden, d.h. des Lokalisationsraumes 100, in der Regel ungestört ist. Daher kann jeder Punkt außerhalb eines Gebäudes als Korrekturpunkt verwendet werden. Der Korrekturwert ist hier null. Um kurzzeitige Störungen des Magnetfeldes außerhalb des Gebäudes beziehungsweise direkt vor einem Gebäude nicht zu stark zu gewichten, ist eine Langzeitmittelung des Offsets $\delta_{6D}$ sinnvoll. Hierfür kann beispielsweise der gleitende Mittelwert des Offsets mit einer Fenstergröße von mindestens 3 Sekunden errechnet werden.

Kommt ein Nutzer also von draußen in ein Gebäude, so existiert bereits ein $\delta_{6D}$. Sobald das Gebäude betreten wird, bleibt dieser Offset unverändert bis zum nächsten Korrekturpunkt. Es ist also auch möglich, in einem Gebäude zu lokalisieren, in dem keine Korrekturpunkte vorhanden sind. Der Richtungsfehler steigt dann jedoch mit der Zeit und der zurückgelegten Strecke im Gebäude aufgrund der Gierwinkeldrift vom 6D-Fusionsalgorithmus.

Für eine Fusion mit anderen Modulen wird auch hier eine gaußförmige Wahrscheinlichkeitsverteilung mit der Standardabweichung $\sigma_\Psi$ angenommen. Der Term $\Psi(r,r')$ beschreibt dabei den Winkel im euklidischen Raum zwischen einer Position rund einer vorherigen Position r'.

$$P_\Psi(r|m,r') = \frac{1}{\sqrt{2\pi}\sigma_\Psi} e^{-\frac{1}{2\sigma_\Psi^2}(\Psi(r,r')-\Psi(m))^2} \ \text{mit} \ \Psi(m) = \tilde{\psi}_{6D}$$

Im Folgenden werden deterministische Fusionsmöglichkeiten beschrieben. Bestimmte Einzelmodule (z.B. Orientierungsmodul 52, das Bakenmodul 55 und Schritterkennungsmodul 51, Magnetometervorrichtung 23) lassen sich zu einem funktionierenden Gesamtsystem fusionieren, ohne probabilistische Verfahren anzuwenden. In der Praxis eignet sich eine probabilistische Fusion oft besser, da hierdurch Messungenauigkeiten besser berücksichtigt werden. Dennoch wird die deterministische Variante im Folgenden beschrieben.

So kann durch eine Funkbake 10, welche z.B. an der Eingangstür eines Gebäudes befestigt ist, die erste Position bestimmt werden. Theoretisch kann hierfür auch die letzte zuverlässige GPS Position verwendet werden. Zwingend notwendig ist bei dieser einfachen Fusion eines der beiden Schritterkennungsmodule 51. Der abzudeckende Bereich wird in ein kartesisches Koordinatensystem gelegt. Solange das Bakenmodul 55 diese Position meldet, ist die aktuelle Positionsausgabe gleich der Position der Funkbake 10.

Gibt nun beispielsweise ein Schritterkennungsmodul 51 ein Signal über ein Schrittevent mit einer Schrittweite, so wird die aktuelle Koordinate um die Schrittweite erhöht. In welche Richtung dies geschieht, richtet sich nach der vom Bewegungsrichtungsmodul 52 ausgegeben Richtung zum Zeitpunkt des Schrittes. Wird ein Fußsensor als Schrittmodul verwendet, so ist dieser Zeitpunkt die Mitte der Schwingphase des Fußes, an dem der Fußsensor befestigt ist. Ebenfalls möglich ist eine Mittelung der Richtung während der gesamten Schwingdauer.

Sofern die rotationsinvarianten Merkmale verwendet werden sollen, so muss ein probabilistischer Filter verwendet werden.

Die Aufgabe des probabilistischen Filters ist die Schätzung der bedingten Wahrscheinlichkeit $P(s|m)$ der Systemvariablen s bezüglich der aktuellen gegebenen Messwerte m der Sensoren. Die Systemvariablen sind beispielsweise beschrieben durch die Position r oder auch die Orientierung o im Vektor $s = (r_x, r_y, r_z, o_x, o_y, o_z)$. Die Inputdaten des Filters sind beispielsweise die rotationsinvarianten magnetischen Merkmale ($|B|$, $B_n$), die Inertialsensordaten in Form der Beschleunigungen ($a_x$, $a_y$, $a_z$) und der Winkelgeschwindigkeit ($\omega_x$, $\omega_y$; $\omega_z$) und die magnetische Flussdichte ($B_x$, $B_y$, $B_z$).

Der Filter kann sowohl auf allen Systemvariablen oder auch nur auf einer Untergruppe, wie beispielsweise dem magnetischen Teil des Systems mit $s = (r_x, r_y, r_z)$ und ($|B|$, $B_n$), arbeiten.

Der Zustandsraum der Systemvariablen kann kontinuierlich oder eine diskrete Partition des Geltungsbereiches sein. Der diskrete Fall hat den Vorteil, dass die bedingte Wahrscheinlichkeit $P(s_i|m)$ an den Zellen $i$ eine exakte Lösung bietet, während die Berechnung der bedingten Wahrscheinlichkeit im kontinuierlichen Fall lediglich eine Approximation ist. Der Nachteil des diskreten Falls ist die Limitierung der Genauigkeit durch die Zellgröße. In der Praxis ist die Auflösung begrenzt durch die Qualität der Sensoren für die Bewegungs- und Magnetfelderfassung und die Problemcharakteristiken, so dass es sinnvoll ist eine angemessene Zellgröße zu wählen. In diesem Fall wird der Lokalisierungsraum 100, beispielsweise ein zweidimensionaler Raum $A \subset \mathbb{R}^2$ , eingeteilt in Zellen $i$ mit beispielsweise einer festen Zellgröße. Dabei sind alle Systemvariablen $s_i$ in dessen Zelle $i$ gegeben.

Dabei kommen grundsätzlich verschiedene Filter wie der Kalmanfilter, der Partikelfilter und ein diskreter Bayesfilter in Betracht. Der Kalmanfilter bietet die beste Lösung unter der Voraussetzung, dass eine lineare Systemdynamik $s(t') = Ds(t) + \xi$ vorliegt. Die Systemdynamik beschreibt den Übergang von einem Systemzustand $s(t)$ zur Zeit $t$ zu einem neuen Zustand $s(t')$, wobei die Dynamik D ein linearer Operator in Form von beispielsweise einer Matrix ist, welche den Zustandsvektor s auf den neuen Zustand abbildet. Das Systemrauschen muss dabei gaußförmig sein $\xi \sim N(0, \sigma)$.

Ein Partikelfilter benötigt diese Annahme nicht, jedoch ist dieser auch lediglich eine Approximation, dessen Genauigkeit mit sich erhöhender Anzahl von Partikeln größer wird. Für den diskreten Fall ist der Bayesfilter direkt nutzbar und exakt.

Der Bayesfilter nutzt das Gesetz der bedingten Wahrscheinlichkeiten, welches eine Neuformulierung seiner Definition darstellt

$$P(A|B) = \frac{P(A \cap B)}{P(B)}$$

Hiermit und durch den Fakt $P(A \cap B) = P(B \cap A)$ erhält man $P(A|B)P(B) = P(B|A)P(A)$ und damit auch das Gesetz der bedingten Wahrscheinlichkeiten

$$P(A|B) = \frac{P(B|A)P(A)}{P(B)} \qquad (1)$$

Angewandt auf die bedingte Wahrscheinlichkeit $P(s|m)$ der Systemvariablen s bezüglich der gegenwärtigen Messwerte $m$ Sensoren ergibt sich

$$P(s|m) = C\, P(m|s)P(s)$$

mit der Normalisierungskonstante $C = \frac{1}{\sum P(m|s)P(s).}$ .

Der Vorteil dieses Ausdrucks ist seine iterative Form und der Fakt, dass die Berechnung der bedingten Wahrscheinlichkeit $P(m|s)$ des gemessenen Wertes bei gegebenem Systemzustand oft eher möglich ist als die Bestimmung von $P(s|m)$.

Um eine Iteration auszuführen, muss der Systemzustand $s_t$=$s(t)$ und die Messung $m_t = m(t)$ bei einem Iterationsschritt $t$ in Betracht gezogen werden. Aus dem Gesetz der bedingten Wahrscheinlichkeiten (Gleichung (1)) mit

$$m_{1:t} \doteq (m_1, \dots, m_t), \qquad A = (s_t|m_{1:t-1}), \qquad B = (m_t|m_{1:t-1})$$

erhält man die Iteration

$$P(s_t|m_{1:t}) = CP(m_t|s_t)P(s_t|m_{1:t-1}) \quad (2).$$

Bei einem System mit Markovdynamik bilden die Übergangswahrscheinlichkeiten $P(s_t|s_{1:t-1})$ des Zustandsüberganges $s_{t-1} \rightarrow s_t$ eine Halbgruppe, welche durch die Chapman-Kolmogorow-Gleichung $P(s|a) = \Sigma_z P(s|z)P(z|a)$ ausgedrückt wird. Es ergibt sich der Iterationsausdruck des Filters

$$P(s_t|m_{1:t}) = CP(m_t|s_t)\sum_z P(s_t|s_{t-1} = z)\, P(s_{t-1} = z|m_{1:t-1})$$

Dieser berechnet die bedingte Wahrscheinlichkeitsverteilung $P(s_t|m_{1:t})$ zum Zeitschritt $t$ aus der letzten Verteilung $P(s_{t-1}|m_{1:t-1})$ zum Zeitschritt t-1. Die Iteration startet bei t = 1 mit $P(s_0|s_{1:0}) = P(s_0)$. Die initiale Verteilung $P(s_0)$ repräsentiert die Information über den Systemzustand zum Startpunkt. Ist die initiale Position beispielsweise durch Funkbaken 10 oder auch optische Lokalisierungsinformation (z.B. Marker an einer Wand) an der Position r bekannt, so ist die initiale Verteilung eine Deltaverteilung $P(s_0) = \delta_{s_0 r}$ oder auch eine andere Verteilung, die den möglichen Aufenthaltsbereich abdeckt. Für eine komplett unbekannte initiale Position ist die Initialverteilung eine Gleichverteilung $P(s_0) = C$.

Die Übergangswahrscheinlichkeiten $P(s_t|s_{t-1})$ charakterisieren die möglichen Bewegungen in der Dynamik des Systems. Für einen Lauf auf einem Wegenetzwerk sind die möglichen Übergänge gegeben durch die Adjazenzmatrix.

$$G_{ij} = \begin{cases} 0: \text{nicht verbunden} \\ 1: \text{sonst} \end{cases}$$

des Graphennetzwerks mit den Knoten i, j. Sind alle Übergänge gleich wahrscheinlich, so sind die Übergangswahrscheinlichkeiten

$$P(s_t = i | s_{t-1} = j) = \frac{1}{D_j} G_{ij}$$

mit dem Gewicht $D_j = \Sigma_i\, G_{ij}$ der Knoten.

Im Folgenden wird die Verwendung rotationsinvarianter Magnetfeldmerkmale dargestellt.

Die bedingte Wahrscheinlichkeit $P(m_t|s_t)$ des gemessenen Wertes $m_t$ bei gegebenem Systemzustand $s_t$ zum Zeitschritt t formuliert die Information über die erwarteten Messwerte, wenn das System im bekannten Systemzustand ist. Beispielsweise wird für den Positionszustand des Systems $s = (r_x, r_y, r_z)$ und die Werte der rotationsinvarianten Merkmale $m=(|B|, B_n)$ die bedingte Wahrscheinlichkeit $P(m_t|s_t)$ über die Information der Magnetfeldkarte 31 $Mi = (|B|, B_n)_i$, welche für alle Zellen die Merkmale $(|B|, B_n)_i$ speichert, bestimmt. Dies wurde zuvor beschrieben.

Für den Fall der Verwendung magnetischer Merkmale hat der Ausdruck folgende Form

$$P(i|m_{1:t}) = C \prod_k N(d_{ik}, \sigma_k) \sum_j \frac{1}{D_j} G_{ij} P(j|m_{1:t-1})$$

für den Iterationsschritt t-1

$$P(j|m_{1:t-1}) = P(s_{t-1} \in b_j | m_{1:t-1}$$

und die Zellen $b_j$. Die Normalisierung von $P(i|m_{1:t})$ ist gegeben durch die Konstante C mit

$$C^{-1} = \sum_i \prod_k N(d_{ik}, \sigma_k) \sum_j \frac{1}{D_j} G_{ij} P(j|m_{1:t-1})$$

Sobald eine Position beispielsweise durch eine Funkbake 10 sicher bestimmt werden kann, so wird die Gesamtwahrscheinlichkeit $P(i|m_1:t)$ hart gesetzt, beziehungsweise wird das System neu initialisiert mit der Bakenposition als Initialposition.

Im Folgenden wird beschrieben, wie die Schrittinformation in die Berechnung eingebracht wird. Nutzt man den zuvor beschriebenen Ausdruck für $P(s_t|s_{t-1})$, so werden nur die Merkmale des magnetischen Feldes und das Vorwissen über benachbarte Zellen genutzt. Dabei werden die aktuellen Dynamiken des Systems nicht mit eingebracht. Diese Dynamiken können durch die Inertialsensoren erfasst werden. Hierzu wird die Schrittwahrscheinlichkeit $P_{step}$ eingebracht, die oben eingeführt worden war, welche genau diese Dynamik beschreibt, wobei die Systemvariablen $s_t$ und $s_{t-1}$ korrespondieren mit der aktuellen Position r und der vorherigen Position r' des Schritterkennungsmoduls 51.

Somit erweitern wir die Übergangswahrscheinlichkeit durch das Hinzufügen der Schrittmesswerte.

$$P(s_t|s_{t-1}) \rightarrow P_{step}(s_t|s_{t-1}, m) = P_{step}(r|r', m)$$

Die Schrittwahrscheinlichkeit gibt die essentielle Information über die Übergangswahrscheinlichkeit und sie ersetzt damit die Adjazenzmatrix. Letztendlich erhalten wir für die resultierende Gesamtwahrscheinlichkeit

$$P(s_t|m_{1:t}) = CP(m_t|s_t) \sum_z P_{step}(s_t|s_{t-1} = z, m_t) \, P(s_{t-1} = z|m_{1:t-1})$$

$$C^{-1} = \sum_{s_t} P(m_t|s_t) \sum_k P_{step}(s_t|s_{t-1} = z, m_t) \, P(s_{t-1} = z|m_{1:t-1})$$

In $P(m_t/s_t)$ können grundsätzlich verschiedene Merkmalswahrscheinlichkeiten, welche nicht von den vorherigen Messwerten abhängen, eingebracht werden. Die verschiedenen Einzelwahrscheinlichkeiten verschiedener Merkmale mit dem Index $k$ werden multipliziert. So können beispielsweise Karteninformationen, Laufwegwahrscheinlichkeiten eingearbeitet werden.

$$P(m_t|s_t) = \prod_k P(m_{k,t}|s_t)$$

Eine effektive Möglichkeit Karteninformationen wie Hindernisse und Wände in die Fusion mit einzubeziehen ist es, die Schrittwahrscheinlichkeit $P_{step}$ anzupassen. Befindet sich ein Hindernis zwischen den Positionen z und $s_t$, dann nimmt die Schrittwahrscheinlichkeit an dieser Stelle den Wert 0 an.

Die Genauigkeit des Systems variiert je nach gewählter Konfiguration und Fusionsmethode. Sie setzt sich zusammen aus der Genauigkeit der Einzelmodule. Vergleichsweise gut abzuschätzen ist der Distanzfehler eines Fußsensors. Dieser betrug in internen Tests je nach Nutzer zwischen 0,5% und 2% der zurückgelegten Strecke. Eine 6D-Fusion zur relativen Gierwinkelbestimmung weist in realitätsnahen Testläufen eine Drift von durchschnittlich 1,5° pro Minute auf.

Es ergeben sich also beispielsweise auf 50 Meter in 40 Sekunden nach einem Funkbakenpunkt 10 durch eine deterministische Fusion etwa 1° und 1 m Fehler. Dies geht jedoch davon aus, dass die Referenz- oder Startposition und die Winkelkorrektur über das Magnetfeld an der Funkbake 10 optimal funktionieren. In der Praxis ergibt sich durch die Funkbake 10 bis zu 1 m Positionsfehler. Die Richtungskorrektur hängt stark davon ab, wie konstant die Magnetfeldrichtung im Korrekturbereich ist. In Praxistests in typischen Bürogebäuden ist der Korrekturfehler in der Regel bei ±2°. So können sich im schlechten Fall 2 m Fehler in der reinen Distanz und 1,7 m durch die Fehlkorrektur der Richtung ergeben. Wird jedoch die Karteninformation über mögliche Zell- und Wegeverbindungen hinzugenommen, so liegt der Gesamtfehler durchschnittlich bei unter 1 m.

Durch eine probabilistische Fusion von den vorgestellten rotationsinvarianten Magnetfeldmerkmalen mit der Bewegungsrichtung und einer Schritterkennung ohne Fußsensor ergeben sich in 1D-Bereichen, wie Fluren, ebenfalls Genauigkeiten von etwa 1 m. Durch die Annahme fester Schrittweiten ist die Genauigkeit jedoch abhängig davon, wie gut die Parameter auf den Nutzer eingestellt sind. Insgesamt bieten beide hier evaluierten Varianten eine sehr hohe Genauigkeit mit einem minimalen Installationsaufwand, da nur wenige Funkbaken 10 verwendet werden müssen.

Rein feldstärkenbasierte Verfahren benötigen für diese Genauigkeit eine sehr hohe Anzahl von Routern bzw. Funkbaken 10. Kommerzielle Verfahren benötigen für eine raumgenaue Ortung beispielsweise etwa das 10fache an WLAN Routern.

Im Folgenden wird ein beispielhafter Ablauf einer Indoor-Navigation mittels Bluetooth-Funkbaken 10, Fußsensoren, und die Erfassung der Magnetfeldrichtung durch deterministische Fusion erläutert.

Vor einer möglichen Lokalisierung wird die Magnetfeldkarte 31 des Lokalisationsraumes 100 ausgemessen. Diese beinhaltet in dieser Konfiguration die Magnetfeldkorrekturwerte an den Positionen der Funkbaken 10.

Ein Nutzer will zu einem bestimmten Punkt innerhalb von einem entfernten Gebäude navigiert werden. Ein herkömmliches Navigationssystem navigiert ihn zu einem mit dem hier vorgeschlagenen System ausgestatteten Gebäude. Am Eingang wurde eine Funkbake 10 in der Art positioniert, dass die Indoor-Lokalisierungsvorrichtung 1 des Nutzers Bluetooth Advertisement Pakete mit der Baken ID mit einer Signalstärke empfängt, die einen vorher festgelegten Schwellwert übersteigt. Das vom Nutzer getragene Lokalisationsgerät 1 ermittelt die zur Funkbake 10 ID zugehörige Position, entweder, indem es eine Datenbank abfragt, die sich entweder auf der Lokalisierungsvorrichtung 1 oder einem entfernten Server befindet oder indem es diese Daten mit dem Advertisement Packet erhält. Zusätzlich zur Position erhält das Lokalisierungsgerät Informationen über die Ausrichtung des Magnetfelds, das sich in einem nahen Bereich um die Funkbake 10 befindet. Die Lokalisierungsvorrichtung 1 kennt nun seine absolute Position und kann seine Ausrichtung berechnen, indem es die von ihm gemessene Magnetfeldrichtung entsprechend mit dem für die Funkbake 10 gespeicherten Korrekturwert aus der Magnetfeldkarte 31 berichtigt. Nun kennt die Lokalisierungsvorrichtung 1 ihre Position und Ausrichtung unter der Funkbake 10. Eine Navigationskomponente kann nun den Weg ausrechnen, den der Benutzer bis zu seinem Ziel zurücklegen muss.

Geht der Nutzer nun in der Richtung dieses Weges, wird durch den Fußsensor drahtlos von jedem Schritt die Richtung in *x, y,* und *z* in einer Längeneinheit an das Lokalisationsgerät 1 übertragen. Das Bewegungsrichtungsmodul 52 vom Smartphone bestimmt, in welche xy-Richtung der Schritt verlaufen ist. Das Bewegungsrichtungsmodul 52 bestimmt außerhalb von Bakenpositionen die Richtung nur durch Messungen der Translationssensoren 21 und der Rotationssensoren 22. Durch Aufsummierung der zurückgelegten Schrittweiten kann das System nun ermitteln, wo der Nutzer sich innerhalb des Gebäudes befindet. Da bei jedem Schritt ein kleiner Messfehler entsteht, ist es nötig, nach einer gewissen Strecke (z.B. 50 Meter) eine weitere Funkbake 10 anzubringen, die den Positions- und Richtungsfehler wieder zurücksetzt.

In Fig. 1 ist eine Datenverarbeitungsvorrichtung 30 dargestellt, die Teil der Lokalisierungsvorrichtung 10 ist. Grundsätzlich ist es möglich, dass die Datenverarbeitungsvorrichtung lokal, verteilt oder dezentral ausgebildet ist. Daher ist es auch nicht zwingend, dass das Orientierungsmodul 50, das Schritterkennungsmodul 51, das Bewegungsrichtungsmodul 52, das Magnetfeldkartenanalysemodul 53, das Modul zur Nutzung von rotationsinvarianten magnetischen Merkmalen und / oder das Bakenmodul 55 in einer Einheit angeordnet sind.

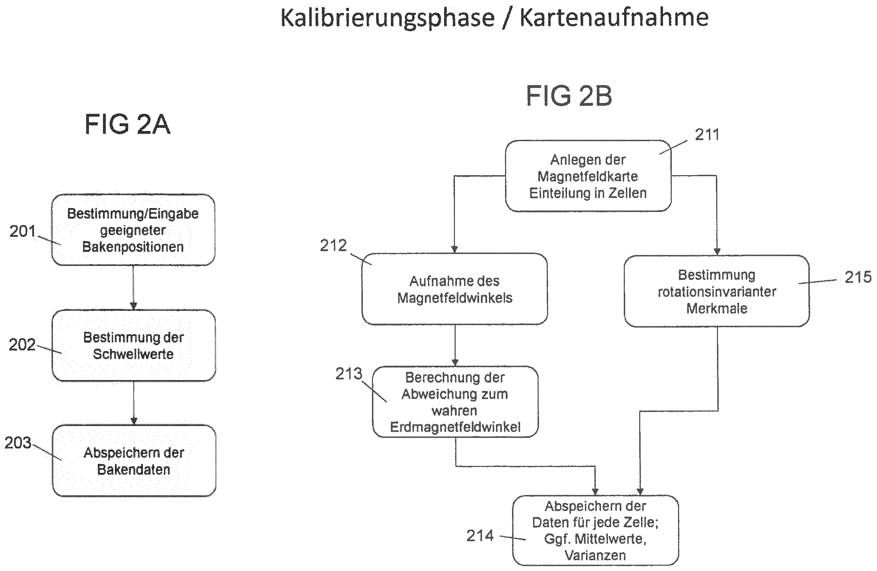

In der Fig. 2A werden die Schritte ausgeführt, die bei Kalibrierung zur Bestimmung der absoluten Position erfolgen, wobei hier eine Funkbake 10 verwendet wird. Im ersten Schritt 201 werden die Positionen der Funkbaken 10 im Lokalisationsraum 100 bestimmt oder ausgemessen.

Im anschließenden Schritt 202 werden Schwellenwerte der Funkwellen 11 bestimmt oder festgelegt, innerhalb derer die Position der Lokalisierungsvorrichtung durch die Position der Funkbake 10 ersetzt werden können. Alternativ oder zusätzlich können hier auch andere Positionsmarker 12, wie z.B. QR-Codes, eingelesen werden, damit absolute Positionen vorliegen können.

Im Schritt 203 werden diese Daten abgespeichert, so dass die Lokalisierungsvorrichtungen 100 auf diese bei der Lokalisierung zugreifen können.

In Fig. 2B wird dargelegt, wie in einer Ausführungsform die Erstellung und die Vorabspeicherung der Magnetfeldkarte erfolgt.

Im ersten Schritt 211 werden im Lokalisationsraum 100 räumliche Bereiche, d.h. Zellen, festgelegt, in denen die magnetischen Daten des Erdmagnetfeldes bestimmt werden sollen. Anschließend erfolgt im Schritt 212 die Messung des Magnetfeldwinkels.

Daran schließt sich die Berechnung der Abweichung vom wahren Erdmagnetfeldwinkel an (Schritt 213). Alternativ und zusätzlich können auch noch andere magnetische Eigenschaften verwendet werden.

Schließlich werden die bestimmten und berechneten Werte für jede Zelle abgespeichert. Dabei werden u.U. auch Mittelwerte, interpolierte Werte und / oder Varianzen berechnet. Zusätzlich oder alternativ können in einem Schritt 215 auch noch rotationsinvariante Merkmale des Magnetfeldes erfasst und dann im Schritt 214 gespeichert werden.

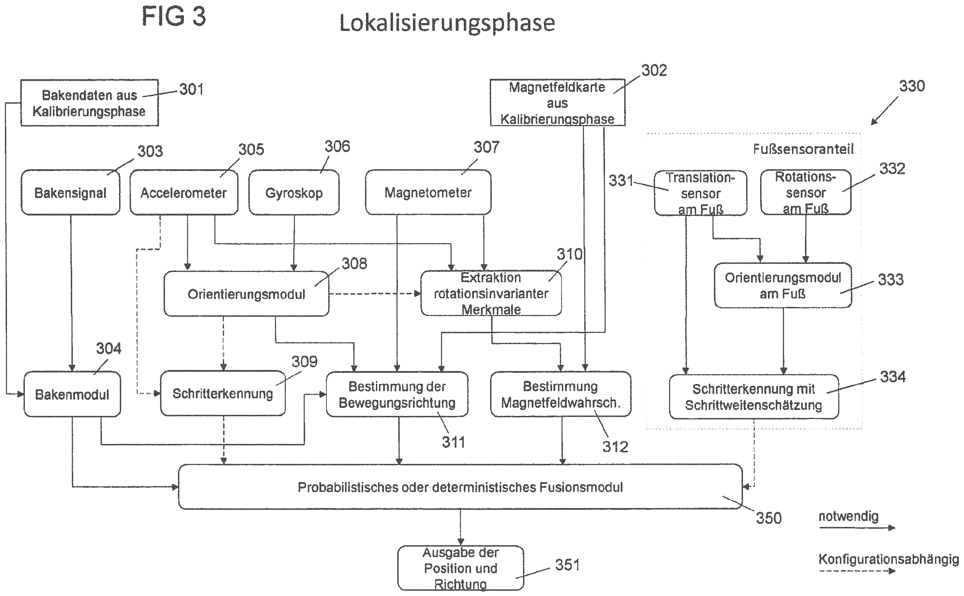

In Fig. 3 wird eine Ausführungsform des Lokalisierungsverfahrens in Form eines Flussdiagrams dargestellt.

Ausgangspunkte sind die Bakendaten aus der Kalibrierungsphase (302, Figur 2A) und die Magnetfeldkarte 23 aus der Kalibrierungsphase (301, Figur 2B).

In den Schritten 303, 305, 306, 307 werden unterschiedliche Signale von der Datenverarbeitungsvorrichtung 30 ausgewertet. Das Funksignal 11 wird im Schritt 303 gemessen und an das Bakenmodul (Schritt 304) weitergeleitet. Das Bakenmodul 55 entscheidet darüber, ob die Signalstärke der Funksignale 11 ausreichend groß ist, um die Position der Lokalisierungsvorrichtung 1 durch die Position der Funkbake 10 oder eine entsprechende Wahrscheinlichkeitsverteilung ersetzen zu können.

Das Ergebnis wird in einem dritten Positionsdatensatz gespeichert, der Auskunft über die absolute Position im Lokalisationsraum 100 gibt. Alternativ oder zusätzlich können hier auch Positionsmarker 12 eingesetzt werden.

Das Bewegungssensorsystem 20 weist einen Translationssensor 21 und einen Rotationssensor 22 auf. Im vorliegenden Fall werden Linear- und

Rotationsbeschleunigungen mit dem Accelerometer und dem Gyroskop erfasst (Schritte 305, 306).

Diese Daten werden im Schritt 308 an das Orientierungsmodul 50 übergeben das die Ausrichtung des Sensorsystems im Raum bestimmen kann. Die Daten werden weitergegeben an das Modul zur Bestimmung der Bewegungsrichtung.

Die Daten des Orientierungsmoduls 50 und des Translationssensors 21 werden dann an das Schritterkennungsmodul 51 (Schritt 309) übergeben. Dabei wird ein erster Positionsdatensatz für die weitere Auswertung bereitgestellt.

Ferner dient eine Magnetometervorrichtung 23 dazu, magnetische Einzelheiten des Erdmagnetfeldes im Lokalisationsraum 100 zu erfassen (Schritt 307). Die Bewegungsrichtung benötigt immer Orientierungsdaten (relativer Gierwinkel).

Die Magnetometervorrichtungsdaten mit Magnetfeldkarte 31 werden dann eingebracht, wenn Bakendaten vorliegen. Die Bakenposition vom Bakenmodul gibt dann an, in welcher Zelle bzw. an welcher Position sich die benötigten gespeicherten Daten in der Magnetfeldkarte befinden.

Aus den magnetischen Daten, d.h. im Vergleich mit der Magnetfeldkarte 31, kann bereits eine Bestimmung der Bewegungsrichtung (Schritt 311) vorgenommen werden. Zu dieser Bestimmung können die Daten aus dem Bakenmodul 55 (Schritt 304) verwendet werden.

In der hier dargestellten Ausführungsform wird ferner auf rotationsinvariante Merkmale zurückgegriffen, die auf Basis von Messungen der magnetischen Rohdaten durch die Magnetometervorrichtung 23 bestimmt werden (Schritt 310). Dabei können entweder die Daten aus dem Accelerometer (Schritt 305) oder die Daten aus dem Orientierungsmodul (Schritt 308) verwendet werden.

Im Schritt 312 wird dann eine Magnetfeldwahrscheinlichkeit bestimmt, hier unter Verwendung der Magnetfeldkarte (Schritt 302).

Die Daten aus dem Bakenmodul 55 (Schritt 304), dem Schritterkennungsmodul 51 (Schritt 309) und dem Bewegungsrichtungsmodul 53 (Schritt 311) und der Bestimmung der Magnetfeldwahrscheinlichkeit (Schritt 312) werden dann in einem probabilistischen Fusionsmodell (Schritt 350) verarbeitet. Die Berechnung der wahrscheinlichsten Position war oben beschrieben worden.

Dies führt letztlich zur Ausgabe der Position und der Richtung der Lokalisationsvorrichtung 1 im Lokalisationsraum 100 (Schritt 351).

In der hier dargestellten Ausführungsform wird ferner auf ein Sensorteil 24 (Schritt 330, hier unter Verwendung eines Fußsensors) zurückgegriffen, das an einer Extremität angeordnet ist. Hier sind ein Translationssensor und ein Rotationsensor am Fuß des Nutzers angeordnet (Schritte 331, 332). Die Sensoren 21, 22 erfassen dabei die Bewegungen des Nutzers. Der Fußsensor weist ferner ein eigenes Orientierungsmodul auf (Schritt 333). Letztlich laufen die Daten in einem Schritterkennungsmodul mit einer Schrittweitenschätzung zusammen (Schritt 334). Diese Daten werden zur weiteren Verbesserung der probabilistischen Verarbeitung der Daten an das Fusionsmodul (Schritt 350) übergeben.

Bezugszeichenliste

1 Lokalisierungsvorrichtung

10 Funkbake
11 Funksignal
12 Positionsmarker

20 Bewegungssensorsystem
21 Translationssensor
22 Rotationssensor (Gyroskop)
23 Magnetometervorrichtung
24 Sensorteil an Extremität, Fußsensor

30 Datenverarbeitungsvorrichtung
31 Magnetfeldkarte

40 Mittel zur Bestimmung einer absoluten Position der Lokalisierungsvorrichtung
41 Funkmodul

50 Orientierungsmodul
51 Schritterkennungsmodul
52 Bewegungsrichtungsmodul
53 Magnetfeldkartenanalysemodul
54 Nutzung von rotationsinvarianten magnetischen Merkmalen
55 Bakenmodul

100 Lokalisierungsraum

B Magnetfeld
n normierter Erdschwerevektor

$\alpha$    Abweichung Magnetfeld gegenüber der wahren Nordrichtung

**Patentansprüche**

1.  Lokalisierungsvorrichtung, deren Position in einem Lokalisierungsraum (100) bestimmbar ist,

    umfassend ein Bewegungssensorsystem (20) mit mindestens einem Translationssensor (21) und mindestens einem Rotationssensor (22) zur Erfassung von auf die Lokalisierungsvorrichtung (1) einwirkenden Bewegungsgrößen, insbesondere Linearbeschleunigungen und Drehbeschleunigungen und
    mindestens eine Magnetometervorrichtung (23) zur Erfassung von magnetischen Felddaten im Lokalisierungsraum (100), wobei rotationsinvariante magnetische Merkmale mittels einer internen oder externen Datenverarbeitungsvorrichtung (30) aus den erfassten rotationsabhängigen magnetischen Felddaten bestimmbar sind, ein Mittel (40) zur Bestimmung einer absoluten Position der Lokalisierungsvorrichtung (1) im Lokalisierungsraum (100) und
    die interne oder externe Datenverarbeitungsvorrichtung (30) zur Berechnung einer Position unter Verarbeitung der Messdaten des Bewegungssensorsystems (20) unter Verwendung einer vorgespeicherten Magnetfeldkarte (31) mit magnetischen Parametern, unter Verwendung der rotationsinvarianten magnetischen Merkmale, von mindestens Teilen des Lokalisierungsraums (100) und zur Verarbeitung der bestimmten absoluten Position, **dadurch gekennzeichnet, daß** zur Bearbeitung der rotationsinvarianten magnetischen Merkmale ein probabilistischer gridbasierter Bayesfilter zur Schätzung der bedingten Wahrscheinlichkeit $P(s|m)$ der Systemvariablen s, nämlich der Position r und / oder der Orientierung o, bezüglich der aktuellen gegebenen Magnetfeld-Messwerte $m$ der Magnetometervorrichtung verwendbar ist.

2.  Lokalisierungsvorrichtung nach Anspruchs 1, **dadurch gekennzeichnet, dass** der mindestens eine Translationssensor (21), der mindestens eine Rotationssensor (22) und / oder die mindestens eine Magnetormetervorrichtung (23) als einachsig, zwei-achsig und / oder drei-achsiges Messmittel ausgeführt sind.

3.  Lokalisierungsvorrichtung nach Anspruch 1 oder 2, **dadurch gekennzeichnet, dass** sie als mobiles Handgerät und / oder als tragbares System für einen Nutzer ausgebildet ist.

4.  Lokalisierungsvorrichtung nach mindestens einem der vorhergehenden Ansprüche, **dadurch gekennzeichnet, dass** das Bewegungssensorsystem (20) die lokale Richtung des Erdschwerefeldes erfasst.

5.  Lokalisierungsvorrichtung nach mindestens einem der vorhergehenden Ansprüche, **dadurch gekennzeichnet, dass** zur Gewinnung eines rotationsinvarianten Merkmales ein gemessener Magnetfeldvektor (B) auf die Richtung des lokalen Erdschwerevektors (n) projiziert wird.

6.  Lokalisierungsvorrichtung nach mindestens einem der vorhergehenden Ansprüche, **dadurch gekennzeichnet, dass** das Mittel zur Bestimmung einer absoluten Position (40) ein Funkmodul (41) zum Empfang von drahtlosen Signalen (11), insbesondere Funkdaten einer Funkbake (10) im Lokalisationsraum (100) aufweist.

7.  Lokalisierungsvorrichtung nach mindestens einem der vorhergehenden Ansprüche, **dadurch gekennzeichnet, dass** das Mittel (40) zur Bestimmung der absoluten Position ein Auswertungsmittel für einen optischen Marker, insbesondere einen QR-Code, aufweist.

8.  Lokalisierungsvorrichtung nach mindestens einem der vorhergehenden Ansprüche, **dadurch gekennzeichnet, dass** mindestens ein Sensorteil (24) an einer Extremität des Nutzers, insbesondere als Fußsensor, Daten über Bewegungsgrößen an der Extremität erfasst und an die Datenverarbeitungsvorrichtung (30) überträgt.

9.  Verfahren zur Lokalisierung mindestens einer Lokalisierungsvorrichtung (1) in einem Lokalisierungsraum (100), wobei die folgenden Schritte a) bis c) mindestens einmal in beliebiger Reihenfolge ausgeführt werden:

    a) Berechnung der Richtung und Länge einer Bewegung der mindestens einen Lokalisierungsvorrichtung (1) ausgehend von der Anfangsposition durch einen Translationssensor (21) und einen Rotationssensor (22) eines Bewegungssensorsystems (20) zur Bestimmung eines ersten Positionsdatensatzes,
    b) Berechnung eines zweiten Positionsdatensatzes unter Auswertung einer vorgespeicherten Magnetfeldkarte (31) und Messergebnissen mindestens einer Magnetometervorrichtung (23), wobei rotationsinvariante magnetische Merkmale mittels der Datenverarbeitungsvorrichtung bestimmt werden,

c) Bestimmung eines dritten Positionsdatensatzes der mindestens einen Lokalisierungsvorrichtung (1) in Abhängigkeit von einer absoluten Position im Lokalisationsraum (100),

d) Fusionierung des ersten, zweiten und dritten Positionsdatensatzes, insbesondere durch ein statistisches Verfahren zur Ermittlung der Position der Lokalisierungsvorrichtung (1) in einer Datenbankvorrichtung (30),

**dadurch gekennzeichnet, daß**
zur Bearbeitung der rotationsinvarianten magnetischen Merkmale ein probabilistischer gridbasierter Bayesfilter zur Schätzung der bedingten Wahrscheinlichkeit P (slm) der Systemvariablen s, nämlich der Position r und/oder der Orientierung o, bezüglich der aktuellen gegebenen Magnetfeld-Meßwerte m der Magnetometervorrichtung verwendbar ist.

**10.** Verfahren nach Anspruch 9, **dadurch gekennzeichnet, dass** die aktuelle Position in Abhängigkeit von einem drahtlosen Signal, insbesondere von Funkwellen (11) einer Funkbake (10) und / oder in Abhängigkeit von einem Positionsmarker (12), insbesondere einem optischen Marker, bestimmt wird.

**11.** Verfahren nach Anspruch 9 oder 10, **dadurch gekennzeichnet, dass** die aktuelle Position der mindestens einen Lokalisierungsvorrichtung (1) gleich der absoluten Position, insbesondere der einer Position einer Funkbake (10) und / oder einer Position des Positionsmarkers (12) gesetzt wird, wenn die mindestens eine Lokalisierungsvorrichtung (1) sich innerhalb einer vorbestimmten Entfernung der absoluten Position befindet.

**12.** Verfahren nach mindestens einem der Ansprüche 9 bis 11, **dadurch gekennzeichnet, dass** mindestens ein Sensorteil (24) an einer Extremität des Nutzers, insbesondere als Fußsensor, Daten über Bewegungsgrößen an der Extremität erfasst und an die Datenverarbeitungsvorrichtung (30) überträgt.

**13.** Verfahren nach mindestens einem der Ansprüche 9 bis 12, **dadurch gekennzeichnet, dass** das Bewegungssensorsystem (20) die lokale Richtung des Erdschwerefeldes erfasst.

## Claims

**1.** A localization apparatus, whose position in a localization space (100) can be determined, comprising

a movement sensor system (20) with at least one translation sensor (21) and at least one rotation sensor (22) for detecting movement quantities acting on the localization apparatus (1), in particular linear accelerations and rotational accelerations, and
at least one magnetometer device (23) for detecting magnetic field data in the localization space (100), wherein rotation-invariant magnetic features can be determined from the detected rotation-dependent magnetic field data by means of an internal or external data processing device (30),
a means (40) for determining an absolute position of the localization apparatus (1) in the localization space (100), and
the internal or external data processing device (30) for calculating a position by processing the measurement data of the movement sensor system (20) by using a prestored magnetic field map (31) including magnetic parameters, by using the rotation-invariant magnetic features, of at least parts of the localization space (100) and for processing the determined absolute position,
**characterized in that** for processing the rotation-invariant magnetic features a probabilistic grid-based Bayesian filter can be used for estimating the conditional probability $P(s|m)$ of the system variables s, namely the position r and/or the orientation o, with respect to the current given magnetic field measurement values m of the magnetometer device.

**2.** The localization apparatus according to claim 1, **characterized in that** the at least one translation sensor (21), the at least one rotation sensor (22) and/or the at least one magnetometer device (23) are configured as uniaxial, biaxial and/or triaxial measurement means.

**3.** The localization apparatus according to claim 1 or 2, **characterized in that** it is configured as a mobile hand-held device and/or as a portable system for a user.

**4.** The localization apparatus according to at least one of the preceding claims, **characterized in that** the movement sensor system (20) detects the local direction of the earth gravity field.

5. The localization apparatus according to at least one of the preceding claims, **characterized in that** for obtaining a rotation-invariant feature a measured magnetic field vector (B) is projected on the direction of the local earth gravity vector (n).

6. The localization apparatus according to at least one of the preceding claims, **characterized in that** the means for determining an absolute position (40) includes a radio module (41) for receiving wireless signals (11), in particular radio data of a radio beacon (10) in the localization space (100).

7. The localization apparatus according to at least one of the preceding claims, **characterized in that** the means (40) for determining the absolute position includes an evaluation means for an optical marker, in particular a QR code.

8. The localization apparatus according to at least one of the preceding claims, **characterized in that** at least one sensor part (24) on a limb of the user, in particular as a foot sensor, detects data on movement quantities at the limb and transmits them to the data processing device (30).

9. A method for localizing at least one localization apparatus (1) in a localization space (100), wherein the following steps a) to c) are carried out at least once in any order:

   a) calculation of the direction and length of a movement of the at least one localization apparatus (1) proceeding from the initial position by a translation sensor (21) and a rotation sensor (22) of a movement sensor system (20) for determining a first position data set,
   b) calculation of a second position data set by evaluating a prestored magnetic field map (31) and measurement results of at least one magnetometer device (23), wherein rotation-invariant magnetic features are determined by means of the data processing device,
   c) determination of a third position data set of the at least one localization apparatus (1) in dependence on an absolute position in the localization space (100),
   d) fusion of the first, second and third position data set, in particular by a statistical method for determining the position of the localization apparatus (1) in a database apparatus (30),

   **characterized in that**
   for processing the rotation-invariant magnetic features a probabilistic grid-based Bayesian filter can be used for estimating the conditional probability $P(s|m)$ of the system variables s, namely the position r and/or the orientation o, with respect to the current given magnetic field measurement values m of the magnetometer device.

10. The method according to claim 9, **characterized in that** the current position is determined in dependence on a wireless signal, in particular on radio waves (11) of a radio beacon (10) and/or in dependence on a position marker (12), in particular an optical marker.

11. The method according to claim 9 or 10, **characterized in that** the current position of the at least one localization apparatus (1) is equated to the absolute position, in particular that of a position of a radio beacon (10) and/or a position of the position marker (12), when the at least one localization apparatus (1) is located within a predetermined distance of the absolute position.

12. The method according to at least one of claims 9 to 11, **characterized in that** at least one sensor part (24) on a limb of the user, in particular as a foot sensor, detects data on movement variables at the limb and transmits them to the data processing device (30).

13. The method according to at least one of claims 9 to 12, **characterized in that** the movement sensor system (20) detects the local direction of the earth gravity field.

**Revendications**

1. Dispositif de localisation dont la position dans un espace de localisation (100) peut être déterminée, comprenant

   un système de capteurs de mouvement (20) comprenant au moins un capteur de translation (21) et au moins un capteur de rotation (22) pour détecter des quantités de mouvement agissant sur le dispositif de localisation (1), en particulier des accélérations linéaires et des accélérations de rotation et

au moins un dispositif magnétomètre (23) pour l'acquisition de données de champ magnétique dans l'espace de localisation (100), des caractéristiques magnétiques invariantes en rotation pouvant être déterminées au moyen d'un dispositif de traitement de données (30) interne ou externe à partir des données de champ magnétique saisies en fonction de la rotation,

un moyen (40) pour déterminer une position absolue du dispositif de localisation (1) dans l'espace de localisation (100) et

le dispositif de traitement de données interne ou externe (30) pour calculer une position en traitant les données de mesure du système de capteurs de mouvement (20) en utilisant une carte de champ magnétique pré-enregistrée (31) avec des paramètres magnétiques, en utilisant les caractéristiques magnétiques invariantes en rotation, d'au moins des parties de l'espace de localisation (100) et pour traiter la position absolue déterminée, **caractérisé en ce que**, pour le traitement des caractéristiques magnétiques invariantes en rotation, un filtre bayésien probabiliste basé sur une grille peut être utilisé pour estimer la probabilité conditionnelle $P(s|m)$ des variables de système s, à savoir la position r et/ou l'orientation o, par rapport aux valeurs de mesure de champ magnétique données actuelles m du dispositif magnétomètre.

2. Dispositif de localisation selon la revendication 1, **caractérisé en ce que** ledit au moins un capteur de translation (21), ledit au moins un capteur de rotation (22) et/ou ledit au moins un dispositif magnétomètre (23) sont réalisés sous la forme d'un moyen de mesure à un axe, à deux axes et/ou à trois axes.

3. Dispositif de localisation selon la revendication 1 ou 2, **caractérisé en ce qu'**il est conçu comme un appareil portatif mobile et/ou comme un système portable pour un utilisateur.

4. Dispositif de localisation selon au moins l'une quelconque des revendications précédentes, **caractérisé en ce que** le système de capteurs de mouvement (20) détecte la direction locale du champ de gravité terrestre.

5. Dispositif de localisation selon au moins l'une quelconque des revendications précédentes, **caractérisé en ce que**, pour obtenir une caractéristique invariante en rotation, un vecteur de champ magnétique (B) mesuré est projeté sur la direction du vecteur de gravité terrestre (n) local.

6. Dispositif de localisation selon au moins l'une quelconque des revendications précédentes, **caractérisé en ce que** le moyen de détermination d'une position absolue (40) comporte un module radio (41) pour recevoir de signaux sans fil (11), en particulier de données radio d'une balise radio (10) dans l'espace de localisation (100).

7. Dispositif de localisation selon au moins l'une quelconque des revendications précédentes, **caractérisé en ce que** le moyen (40) de détermination de la position absolue comporte un moyen d'évaluation d'un marqueur optique, en particulier un code QR.

8. Dispositif de localisation selon au moins l'une quelconque des revendications précédentes, **caractérisé en ce qu'**au moins une partie de capteur (24) sur une extrémité de l'utilisateur, en particulier comme capteur de pied, saisit des données sur des quantités de mouvement sur l'extrémité et les transmet au dispositif de traitement de données (30).

9. Procédé de localisation d'au moins un dispositif de localisation (1) dans un espace de localisation (100), dans lequel les étapes a) à c) suivantes sont exécutées au moins une fois dans n'importe quel ordre :

a) calcul de la direction et de la longueur d'un mouvement dudit au moins un dispositif de localisation (1) à partir de la position initiale par un capteur de translation (21) et un capteur de rotation (22) d'un système de capteurs de mouvement (20) pour déterminer un premier jeu de données de position,

b) calcul d'un deuxième jeu de données de position en évaluant une carte de champ magnétique (31) pré-enregistrée et des résultats de mesure d'au moins un dispositif magnétomètre (23), des caractéristiques magnétiques invariantes en rotation étant déterminées au moyen du dispositif de traitement de données,

c) détermination d'un troisième jeu de données de position dudit au moins un dispositif de localisation (1) en dépendance d'une position absolue dans l'espace de localisation (100),

d) fusion des premier, deuxième et troisième jeux de données de position, en particulier par un procédé statistique pour déterminer la position du dispositif de localisation (1) dans un dispositif de base de données (30),

**caractérisé en ce que**

pour le traitement des caractéristiques magnétiques invariantes en rotation, un filtre bayésien probabiliste basé sur une grille peut être utilisé pour estimer la probabilité conditionnelle $P(s|m)$ des variables de système s, à savoir la position r et/ou l'orientation o, par rapport aux valeurs de mesure de champ magnétique données actuelles m du dispositif magnétomètre.

10. Procédé selon la revendication 9, **caractérisé en ce que** la position actuelle est déterminée en dépendance d'un signal sans fil, en particulier d'ondes radio (11) d'une balise radio (10) et/ou en dépendance d'un marqueur de position (12), en particulier un marqueur optique.

11. Procédé selon la revendication 9 ou 10, **caractérisé en ce que** la position actuelle dudit au moins un dispositif de localisation (1) est fixée égale à la position absolue, en particulier à celle d'une position d'une balise radio (10) et/ou d'une position du marqueur de position (12), lorsque ledit au moins un dispositif de localisation (1) se trouve à l'intérieur d'une distance prédéterminée de la position absolue.

12. Procédé selon au moins l'une quelconque des revendications 9 à 11, **caractérisé en ce qu'**au moins une partie de capteur (24) sur une extrémité de l'utilisateur, en particulier comme capteur de pied, saisit des données sur des grandeurs de mouvement sur l'extrémité et les transmet au dispositif de traitement de données (30).

13. Procédé selon au moins l'une quelconque des revendications 9 à 12, **caractérisé en ce que** le système de capteurs de mouvement (20) détecte la direction locale du champ de gravité terrestre.

FIG 1

EP 3 245 478 B1

# Kalibrierungsphase / Kartenaufnahme

## FIG 2A

201 — Bestimmung/Eingabe geeigneter Bakenpositionen

↓

202 — Bestimmung der Schwellwerte

↓

203 — Abspeichern der Bakendaten

## FIG 2B

211 — Anlegen der Magnetfeldkarte Einteilung in Zellen

212 — Aufnahme des Magnetfeldwinkels

215 — Bestimmung rotationsinvarianter Merkmale

213 — Berechnung der Abweichung zum wahren Erdmagnetfeldwinkel

214 — Abspeichern der Daten für jede Zelle; Ggf. Mittelwerte, Varianzen

EP 3 245 478 B1

## FIG 3          Lokalisierungsphase

| | |
|---|---|
| Bakendaten aus Kalibrierungsphase — 301 | Magnetfeldkarte aus Kalibrierungsphase — 302 |

330

Fußsensoranteil

| Bakensignal | Accelerometer | Gyroskop | Magnetometer |
|---|---|---|---|
| 303 | 305 | 306 | 307 |

| Translation-sensor am Fuß | Rotations-sensor am Fuß |
|---|---|
| 331 | 332 |

Orientierungsmodul — 308

Extraktion rotationsinvarianter Merkmale — 310

Orientierungsmodul am Fuß — 333

| Bakenmodul | Schritterkennung | Bestimmung der Bewegungsrichtung | Bestimmung Magnetfeldwahrsch. |
|---|---|---|---|
| 304 | 309 | 311 | 312 |

Schritterkennung mit Schrittweitenschätzung — 334

Probabilistisches oder deterministisches Fusionsmodul — 350

Ausgabe der Position und Richtung — 351

notwendig →

Konfigurationsabhängig ⇢

FIG 4

Aufnahmerichtung
bezüglich Norden

EP 3 245 478 B1

**EP 3 245 478 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20130179074 A

**In der Beschreibung aufgeführte Nicht-Patentliteratur**

- **S.-E. KIM.** Indoor Positioning System Using Geomagnetic Anomalies for Smartphones. *2012 International Conference in Indoor Positioning and Indoor Navigation,* 13. November 2012
- **M.SILBERT et al.** Comparison of a grid-based filter to a Kalman filter for the state estimation of a maneuvering target. *SPIE Proc.,* vol. 8137, 81370J
- **J.LIU et al.** A Hybrid Smartphone Indoor Positioning Solution for Mobile LBS. *Sensors,* 2012, vol. 12, 17208-17233
- **UK SEBASTIAN ; O.H. MADGWICK. HARRISON.** Vaidyanathan Dept. of Mech. Eng. Univ. of Bristol
- **JAIME GOMEZ RAUL FELIZ ; EDUARDO ZALAMA.** Pedestrian tracking using inertial sensors. *JOURNAL OF PHYSICAL AGENTS,* 2009, vol. 3 (1